# FASCICULE DE BREVET EUROPEEN

(11) **EP 4 256 225 B1**
(45) Date de publication et mention de la délivrance du brevet: **11.02.2026**
(21) Numéro de dépôt: 21835634.3
(22) Date de dépôt: 03.12.2021
(51) Int. Cl.: F17C 9/02, F17C 13/02

(54) **PROCÉDÉ ET SYSTÈME D'AIDE À LA GESTION D'UN NAVIRE DE TRANSPORT DE GAZ LIQUÉFIÉ DU TYPE CONSOMMANT DU GAZ D'ÉVAPORATION POUR SA PROPULSION**
VERFAHREN UND SYSTEM ZUR UNTERSTÜTZUNG DER VERWALTUNG EINES FLÜSSIGGASTRANSPORTSCHIFFS VOM TYP, DAS VERDAMPFTES GAS FÜR SEINEN ANTRIEB VERBRAUCHT
METHOD AND SYSTEM FOR ASSISTING THE MANAGEMENT OF A LIQUEFIED GAS TRANSPORT SHIP OF THE TYPE CONSUMING EVAPORATED GAS FOR ITS PROPULSION

(30) Priorité: 03.12.2020 FR 2012627
(43) Date de publication de la demande: 11.10.2023
(73) Titulaire: GAZTRANSPORT ET TECHNIGAZ, 78470 Saint-Rémy-lès-Chevreuse (FR)
(72) Inventeur: BORDET, Nicolas, 78470 SAINT-REMY-LES-CHEVREUSE (FR); HANAT, François, 78470 SAINT-REMY-LES-CHEVREUSE (FR); GENTILINI, Eric, 78470 SAINT-REMY-LES-CHEVREUSE (FR); VOLUT, Mikaël, 78470 SAINT-REMY-LES-CHEVREUSE (FR)
(74) Mandataire: Loyer & Abello
(86) Numéro de dépôt international: PCT/EP2021/084268
(87) Numéro de publication internationale: WO 2022/117872

(56) Documents cités:
- EP-A1- 3 677 498
- WO-A1-2020/190279
- FR-A1- 3 013 672
- KR-B1- 101 903 758
- US-A1- 2015 324 714
- US-A1- 2019 241 244
- US-A1- 2020 158 289

## Description

### Domaine technique

L'invention se rapporte au domaine des navires de transport de gaz liquéfié du type consommant du gaz d'évaporation pour leur propulsion. Plus particulièrement, l'invention propose un procédé et un système d'aide à la gestion d'un tel navire.

### Arrière-plan technologique

Les cuves étanches et thermiquement isolantes sont couramment utilisées pour le transport de Gaz Naturel Liquéfié (GNL) à environ -162°C à pression atmosphérique. Ces cuves peuvent être destinées au transport de gaz liquéfié. De nombreux gaz liquéfiés peuvent aussi être envisagés, notamment le méthane, l'éthane, le propane, le butane, l'ammoniac, le dihydrogène ou l'éthylène.

Les cuves de navire peuvent être des cuves à membrane d'étanchéité simple ou double qui permettent un transport à la pression atmosphérique. Les membranes d'étanchéité sont généralement réalisées en fine feuille d'acier inoxydable ou en Invar. Une membrane est généralement en contact direct avec le gaz liquéfié.

Puisque le gaz liquéfié est transporté à une température très inférieure à la température ambiante, celui-ci tend naturellement à se réchauffer lentement pendant son transport par un navire comportant une ou plusieurs telles cuves, et ce malgré l'isolation thermique des cuves. On appelle couramment gaz d'évaporation (« Boil-Off Gas » ou BOG en anglais) le gaz généré du fait de ce réchauffement. À titre d'exemple, pendant le transport de GNL à environ -162°C à pression atmosphérique, on peut observer une génération de BOG qui est de l'ordre de 0,05% à 0,15% par jour du volume de GNL initialement contenu dans une cuve.

Afin de valoriser le BOG, il est connu d'en utiliser tout ou partie pour la propulsion du navire, en l'envoyant vers un moteur de propulsion du navire qui est apte à consommer du BOG. De façon connue, le navire est en outre typiquement équipé d'une unité de combustion de gaz (« Gas Combustion Unit » ou GCU en anglais) pour brûler un éventuel excédent de BOG qui ne pourrait pas être consommé par le moteur de propulsion du navire.

Le BOG brûlé dans la GCU le long du trajet du navire représente une perte puisqu'il n'est pas livré à la destination du navire et est consommé sans profit. Il est donc souhaitable d'en minimiser la quantité le long d'un trajet donné du navire. En outre, même si le BOG envoyé vers le moteur de propulsion du navire est valorisé, il représente lui aussi une réduction de la quantité livrée à la destination du navire.

Les documents FR3013672A1, EP3677498A1, US2019/241244A1 et US2015/324714A1 décrivent des procédés mis en œuvre par ordinateur d'aide à la gestion d'un navire de transport de gaz liquéfié selon l'art antérieur.

Aussi, il existe un besoin pour des solutions d'aide à la gestion du navire qui permettent de limiter une quantité totale de BOG générée dans la cuve, de façon à limiter la quantité de BOG à brûler dans la GCU et la quantité de BOG envoyée vers le moteur de propulsion du navire.

### Résumé

Une idée à la base de l'invention est d'utiliser des prévisions météorologiques le long d'un trajet prévisionnel du navire et un modèle de fonctionnement du navire afin d'estimer au moins une quantité totale de gaz d'évaporation générée dans la cuve du navire. Une autre idée à la base de l'invention est d'effectuer cette estimation pour au moins un, et de préférence plusieurs, scénarios de gestion de cuve définissant une évolution de la pression de la phase gazeuse contenue dans la cuve le long dudit trajet prévisionnel. Encore une autre idée à la base de l'invention est d'afficher à un utilisateur au moins un desdits scénarios de gestion de cuve en fonction d'une fonction de coût qui dépend au moins d'une quantité totale de gaz d'évaporation générée dans la cuve le long dudit trajet prévisionnel.

Selon un mode d'exécution, l'invention fournit un procédé mis en œuvre par ordinateur d'aide à la gestion d'un navire de transport de gaz liquéfié, le navire comportant au moins une cuve configurée pour contenir du gaz liquéfié et un système de traitement de phase vapeur, le système de traitement de phase vapeur étant apte à envoyer du gaz d'évaporation sortant de la cuve vers un moteur de propulsion du navire et vers une unité de combustion de gaz embarquée à bord du navire, le système de traitement de phase vapeur étant en outre apte à extraire une portion de la phase liquide contenue dans la cuve et à évaporer cette portion afin de l'envoyer vers le moteur de propulsion, le procédé comportant :
- fournir un état initial de la cuve, ledit état initial de la cuve comprenant une pression initiale de la phase gazeuse contenue dans la cuve et une température initiale de la phase liquide contenue dans la cuve ;
- fournir un trajet prévisionnel du navire ;
- à partir de prévisions météorologiques, déterminer au moins un paramètre environnemental du navire le long dudit trajet prévisionnel ;
- déterminer une courbe de vitesse du navire le long dudit trajet prévisionnel ;
- générer un scénario de gestion de cuve définissant une évolution de la pression de la phase gazeuse contenue dans la cuve le long dudit trajet prévisionnel, et à partir du scénario de gestion de cuve ainsi généré :
   a) estimer une courbe de puissance requise en sortie du moteur de propulsion le long dudit trajet prévisionnel en fonction de ladite courbe de vitesse du navire et dudit au moins un paramètre environnemental ;
   b) estimer une courbe de quantité de gaz d'évaporation générée dans la cuve le long dudit trajet prévisionnel ;
   c) estimer, à partir de ladite courbe de puissance requise et de ladite courbe de quantité de gaz d'évaporation générée, une courbe de quantité de gaz à extraire de la cuve et une courbe de quantité de gaz d'évaporation à brûler dans l'unité de combustion de gaz ; et
   d) calculer une fonction de coût qui dépend au moins d'une quantité totale de gaz d'évaporation générée dans la cuve le long dudit trajet prévisionnel ; et
- afficher à un utilisateur le scénario de gestion de cuve en fonction de la fonction de coût calculée.

Grâce à ces caractéristiques, un scénario de gestion de cuve peut être évalué en calculant la fonction de coût et être affiché à l'utilisateur en vue de proposer une aide à la décision.

Selon des modes d'exécution, un tel procédé peut comporter une ou plusieurs des caractéristiques suivantes.

Selon un mode d'exécution, une pluralité de scénarios de gestion de cuve sont générés, les étapes a) à d) étant effectuées pour chaque scénario de gestion de cuve, et au moins un desdits scénarios de gestion de cuve est affiché à l'utilisateur en fonction de la fonction de coût calculée pour ledit scénario de gestion de cuve.

Ainsi, un grand nombre de scénarios de gestion de cuve peut être évalué en calculant la fonction de coût, et un ou plusieurs scénarios de gestion de cuve qui minimisent le mieux la fonction de coût peuvent être affichés à l'utilisateur en vue de proposer une aide à la décision.

Selon un mode d'exécution, avant d'afficher à l'utilisateur au moins un desdits scénarios de gestion de cuve, lesdits scénarios de gestion de cuve sont régénérés itérativement une pluralité de fois par un premier algorithme évolutionnaire utilisant la fonction de coût comme première fonction objectif.

On entend par « algorithme évolutionnaire » (également connu sous le nom d' « algorithme évolutionniste » ; en anglais : « evolutionary algorithm ») une méthode typiquement mise en œuvre par ordinateur, dans laquelle on génère une population de solutions, puis on évalue chaque solution par une fonction objectif, on sélectionne certaines des solutions qui minimisent le mieux la fonction objectif, on génère une nouvelle population de solutions à partir des solutions ainsi sélectionnés, et on répète ces étapes tant qu'un critère d'arrêt n'est pas vérifié. Dans le cadre de la présente invention, chaque scénario de gestion de cuve est une solution, et la fonction de coût sert de fonction objectif à l'algorithme évolutionnaire.

Différents types d'algorithmes évolutionnaires sont connus en tant que tels. Dans un mode d'exécution, l'algorithme évolutionnaire est un algorithme génétique. Les algorithmes évolutionnaires sont particulièrement bien adaptés à des problèmes d'optimisation.

Comme on vient de le mentionner, un algorithme évolutionnaire utilise nécessairement un critère d'arrêt afin de décider quand on cesse de chercher des solutions plus optimales. Selon un mode d'exécution, le critère d'arrêt est un critère de temps de calcul, ce qui permet de garantir que le procédé affichera à l'utilisateur un ou plusieurs scénarios de gestion de cuve optimisés au bout d'un temps donné de calcul.

Selon un mode d'exécution, le trajet prévisionnel du navire est divisé en intervalles de temps consécutifs, et le ou chaque scénario de cuve définit une valeur moyenne de la pression de la phase gazeuse contenue dans la cuve pendant chacun desdits intervalles de temps consécutifs.

Selon un mode d'exécution, ledit au moins un scénario de gestion de cuve affiché à l'utilisateur est affiché ensemble avec une valeur minimale de la pression de la phase gazeuse contenue dans la cuve et/ou une valeur maximale de la pression de la phase gazeuse contenue dans la cuve pendant chacun desdits intervalles de temps consécutifs.

Selon un mode d'exécution, ledit trajet prévisionnel comprend des étapes de trajet définies chacune par deux points de cheminement et un cap à suivre entre lesdits deux points de cheminement, et à l'étape a), la courbe de puissance requise en sortie du moteur de propulsion le long dudit trajet prévisionnel est estimée en fonction desdits caps à cuivre, de ladite courbe de vitesse du navire et dudit au moins un paramètre environnemental.

De cette manière, l'évaluation des scénarios de gestion de cuve tient en outre compte de l'impact du cap du navire sur la puissance requise en sortie du moteur de propulsion. En effet, à titre d'exemple, selon l'angle entre le cap du navire et la direction du courant, du vent et des vagues, cette puissance peut être plus ou moins importante.

Selon un mode d'exécution, ladite courbe de vitesse du navire est déterminée à partir dudit trajet prévisionnel et dudit au moins un paramètre environnemental par un deuxième algorithme évolutionnaire utilisant une deuxième fonction objectif qui dépend de ladite quantité totale de gaz d'évaporation générée dans la cuve le long dudit trajet prévisionnel et d'une différence entre une heure requise d'arrivée à destination et une heure estimée d'arrivée à destination.

De cette manière, l'estimation de la puissance requise en sortie du moteur de propulsion tient compte d'une heure requise d'arrivée à destination du navire, celle-ci pouvant être spécifiée en tant que paramètre d'entrée par un utilisateur.

Un terminal de déchargement de gaz liquéfié exige systématiquement que la cuve présente une pression de déchargement et/ou une température de déchargement données. Selon un mode d'exécution, fournir un trajet prévisionnel du navire comprend fournir une pression de déchargement et/ou une température de déchargement requises par un terminal de déchargement à la destination du navire, et à l'étape d), la fonction de coût dépend en outre d'une différence entre la pression de la phase gazeuse contenue dans la cuve à la fin du dudit trajet prévisionnel et ladite pression de déchargement et/ou d'une différence entre la température de la phase liquide contenue dans la cuve à la fin du dudit trajet prévisionnel et ladite température de déchargement.

De cette manière, un scénario de gestion de cuve est considéré comme d'autant plus acceptable qu'il permet d'arriver au terminal de déchargement situé au point de destination avec une pression de déchargement et/ou une température de déchargement proches de celles exigées par le terminal de déchargement.

Selon un mode d'exécution, à l'étape a), la courbe de puissance requise est estimée à l'aide d'un premier modèle statistique, le premier modèle statistique étant apte à estimer une puissance requise en sortie du moteur de propulsion au moins en fonction, d'une consigne de vitesse de navire et dudit au moins un paramètre environnemental, et le premier modèle statistique étant entraîné par une méthode d'apprentissage automatique supervisé.

On entend par « méthode d'apprentissage automatique supervisé » (en anglais : « supervised learning ») une méthode d'apprentissage automatique (en anglais : « machine learning » ; aussi désignée en français par les appellations d'apprentissage artificiel ou d'apprentissage statistique) consistant à apprendre une fonction de prédiction à partir d'exemples annotés. Autrement dit, une méthode d'apprentissage automatique supervisé permet de construire un modèle apte à la prévision à partir d'une pluralité d'exemples pour lesquels la réponse à prédire est connue. Une méthode d'apprentissage automatique supervisé est typiquement mise en œuvre par ordinateur ; l'entraînement du premier modèle statistique est ainsi typiquement mis en œuvre par ordinateur.

Il est bien entendu que dans la phrase ou caractéristique « entraîner un modèle statistique par une méthode d'apprentissage automatique supervisé sur un ensemble de données d'essais », l'« ensemble de données d'essais » peut aussi comprendre ou consister en des données issues de campagnes dites « réelles », c'est-à-dire obtenues ou relevées sur des navires circulant en tant que transporteur et utilisateur de gaz liquéfié.

Selon un mode d'exécution, la susdite étape b) consistant à estimer une courbe de quantité de gaz d'évaporation générée dans la cuve le long dudit trajet prévisionnel comprend estimer une première quantité de gaz d'évaporation générée dans la cuve en fonction d'une pression courante de la phase gazeuse contenue dans la cuve et d'une température courante de la phase liquide contenue dans la cuve et estimer une deuxième quantité de gaz d'évaporation générée dans la cuve en fonction d'une pression courante de la phase gazeuse contenue dans la cuve et dudit au moins un paramètre environnemental.

Ainsi, l'estimation de la quantité de gaz d'évaporation générée dans la cuve tient compte à la fois de la génération de gaz d'évaporation liée à la coexistence de la phase liquide et de la phase gazeuse dans la cuve, et de génération de gaz d'évaporation du fait de l'agitation de la phase liquide due aux mouvements subis par le navire.

Selon un mode d'exécution, la deuxième quantité de gaz d'évaporation générée dans la cuve est estimée à l'aide d'un deuxième modèle statistique, le deuxième modèle statistique étant entraîné par une méthode d'apprentissage automatique supervisé.

Selon un mode d'exécution, l'état initial comprend une composition initiale du gaz liquéfié contenu dans la cuve, et l'étape b) consistant à estimer une courbe de quantité de gaz d'évaporation générée dans la cuve le long dudit trajet prévisionnel comprend en outre estimer une composition du gaz d'évaporation généré dans la cuve.

Une cargaison de gaz liquéfié n'est quasiment jamais chimiquement pure : il s'agit en général d'un mélange de plusieurs gaz liquéfiés, l'un étant très majoritaire en masse et le ou les autres étant présents sous formes d'impuretés. Cependant, la composition initiale de la cargaison est en général indiquée par le fournisseur du gaz liquéfié lors de son chargement dans la cuve. En indiquant la composition initiale du gaz liquéfié et en estimant une composition du gaz d'évaporation généré dans la cuve, on tient compte du fait que la composition du gaz d'évaporation va évoluer au le long du trajet prévisionnel, en raison des propriétés différentes d'évaporation des gaz composant la cargaison de gaz liquéfié.

Selon un mode d'exécution, le paramètre environnemental comprend au moins l'un parmi une direction du courant, une vitesse du courant, une vitesse du vent, une direction du vent, une hauteur moyenne des vagues, une direction des vagues, et une période des vagues.

Selon un mode d'exécution, le système de traitement de phase vapeur comporte en outre un reliquéfacteur apte à reliquéfier du gaz d'évaporation sortant de la cuve et à renvoyer le gaz d'évaporation ainsi reliquéfié vers la cuve, et la susdite étape c) comprend estimer, à partir de ladite courbe de puissance requise et de ladite courbe de quantité de gaz d'évaporation générée, une courbe de quantité de gaz à extraire de la cuve, une courbe de quantité de gaz d'évaporation à brûler dans l'unité de combustion de gaz, et une courbe de quantité de gaz d'évaporation à envoyer vers le reliquéfacteur.

Selon un mode d'exécution, le système de traitement de phase vapeur comporte en outre un sous-refroidisseur apte à sous-refroidir une portion de la phase liquide contenue dans la cuve et à renvoyer la portion ainsi sous-refroidie vers la cuve, et dans lequel la susdite étape c) comprend estimer, à partir de ladite courbe de puissance requise et de ladite courbe de quantité de gaz d'évaporation générée, une courbe de quantité de gaz à extraire de la cuve, une courbe de quantité de gaz d'évaporation à brûler dans l'unité de combustion de gaz, et une courbe de quantité de phase liquide à extraire de la cuve et à envoyer vers le sous-refroidisseur.

Selon un mode d'exécution, les étapes du procédé sont réitérées à intervalles fixes et/ou à réception de nouvelles prévisions météorologiques.

Ainsi, le procédé réévalue régulièrement des scénarios de gestion de cuve à mesure que le navire progresse sur son trajet prévisionnel et que de nouvelles prévisions météorologiques sont disponibles. En complément ou en alternative, les étapes du procédé peuvent être réitérées sur commande d'un utilisateur.

Selon un mode d'exécution, l'invention fournit en outre un système d'aide à la gestion d'un navire de transport de gaz liquéfié, le navire comportant au moins une cuve configurée pour contenir du gaz liquéfié et un système de traitement de phase vapeur, le système de traitement de phase vapeur étant apte à envoyer du gaz d'évaporation sortant de la cuve vers un moteur de propulsion du navire et vers une unité de combustion de gaz embarquée à bord du navire, le système de traitement de phase vapeur étant en outre apte à extraire une portion de la phase liquide contenue dans la cuve et à évaporer cette portion afin de l'envoyer vers le moteur de propulsion, le système d'aide à la gestion comprenant :
- une unité d'acquisition configurée pour acquérir un état initial de la cuve et un trajet prévisionnel du navire, ledit état initial de la cuve comprenant une pression initiale de la phase gazeuse contenue dans la cuve et une température initiale de la phase liquide contenue dans la cuve ;
- une première unité de communication configurée pour obtenir des prévisions météorologiques d'un fournisseur de prévisions météorologiques ; et
- une unité de calcul configurée pour : à partir des prévisions météorologiques obtenues par la première unité de communication, déterminer au moins un paramètre environnemental du navire le long dudit trajet prévisionnel ; déterminer une courbe de vitesse du navire le long dudit trajet prévisionnel ; générer un scénario de gestion de cuve définissant une évolution de la pression de la phase gazeuse contenue dans la cuve le long dudit trajet prévisionnel, et à partir du scénario de gestion de cuve ainsi généré :
   a) estimer une courbe de puissance requise en sortie du moteur de propulsion le long dudit trajet prévisionnel en fonction de ladite courbe de vitesse du navire et dudit au moins un paramètre environnemental ;
   b) estimer une courbe de quantité de gaz d'évaporation générée dans la cuve le long dudit trajet prévisionnel ;
   c) estimer, à partir de ladite courbe de puissance requise et de ladite courbe de quantité de gaz d'évaporation générée, une courbe de quantité de gaz à extraire de la cuve et une courbe de quantité de gaz d'évaporation à brûler dans l'unité de combustion de gaz ;
   d) calculer une fonction de coût qui dépend au moins d'une quantité totale de gaz d'évaporation générée dans la cuve le long dudit trajet prévisionnel ; et
- une unité d'affichage configurée pour afficher à un utilisateur le scénario de gestion de cuve en fonction de la fonction de coût calculée.

Un tel système procure les mêmes avantages que le procédé décrit ci-dessus.

Selon un mode d'exécution, ledit trajet prévisionnel comprend des étapes de trajet définies chacune par deux points de cheminement et un cap à suivre entre lesdits deux points de cheminement, et dans lequel l'unité de calcul est configurée pour a) estimer une courbe de puissance requise en sortie du moteur de propulsion le long dudit trajet prévisionnel en fonction desdits caps à cuivre, de ladite courbe de vitesse du navire et dudit au moins un paramètre environnemental.

Selon un mode d'exécution, l'unité d'acquisition et l'unité d'affichage sont embarquées à bord du navire, la première unité de communication et l'unité de calcul sont situées dans une station à terre, et dans lequel le système comprend en outre une deuxième unité de communication configurée pour mettre en communication l'unité d'acquisition et l'unité de calcul.

### Brève description des figures

L'invention sera mieux comprise, et d'autres buts, détails, caractéristiques et avantages de celle-ci apparaîtront plus clairement au cours de la description suivante de plusieurs modes d'exécution particuliers de l'invention, donnés uniquement à titre illustratif et non limitatif, en référence aux dessins annexés.
[fig.1] La figure 1 est une représentation schématique d'un navire de transport de gaz liquéfié.
[fig. 2] La figure 2 est un diagramme-blocs représentant schématiquement les cuves du navire de la figure 1 ainsi qu'un système de traitement de phase vapeur, un moteur de propulsion du navire et une unité de combustion de gaz embarquée à bord du navire.
[fig. 3] La figure 3 est un diagramme-blocs d'un système d'aide à la gestion du navire de la figure 1.
[fig. 4] La figure 4 est un diagramme-blocs d'un système d'aide à la gestion du navire de la figure 1 selon une variante de la figure 3.
[fig. 5A] La figure 5A est un diagramme-blocs illustrant les premières étapes d'un procédé d'aide à la gestion du navire de la figure 1, le procédé pouvant être mis en œuvre par le système d'aide à la gestion de la figure 3.
[fig. 5B] La figure 5B est un diagramme-blocs illustrant les étapes suivantes du procédé de la figure 5A.
[fig. 6] La figure 6 représente à titre d'illustration un exemple de trajet prévisionnel du navire.
[fig. 7] La figure 7 est un graphique représentant à titre d'illustration un exemple de scénario de gestion de cuve généré dans le système d'aide à la gestion de la figure 3.
[fig. 8] La figure 8 est un diagramme-blocs représentant à titre explicatif les modèles utilisés par le système d'aide à la gestion de la figure 3 pour évaluer un scénario de gestion de cuve donné.
[fig. 9] La figure 9 est un graphique représentant à titre d'illustration un exemple de scénario de gestion de cuve analogue à celui de la figure 7, auquel sont associées des valeurs minimales et maximales de la pression dans la cuve.
[fig. 10] La figure 10 est un graphique représentant à titre d'illustration un exemple de scénario de gestion de cuve analogue à celui de la figure 7, subdivisé en sous-intervalles de temps.
[fig. 11] La figure 11 est un graphique représentant à titre d'illustration un exemple de scénario de gestion de vitesse généré dans le système d'aide à la gestion de la figure 3 dans certains modes d'exécution.
[fig. 12] La figure 12 est un diagramme-blocs représentant à titre explicatif les modèles utilisés par le système d'aide à la gestion de la figure 3 pour évaluer un scénario de gestion de vitesse donné.
[fig. 13] La figure 13 est un diagramme-blocs analogue à celui de la figure 2, représentant une variante du système de traitement de phase vapeur.
[fig. 14] La figure 14 est un diagramme-blocs analogue à celui de la figure 2, représentant une autre variante du système de traitement de phase vapeur.
[fig. 15] La figure 15 est un diagramme-blocs analogue à celui de la figure 2, représentant encore une autre variante du système de traitement de phase vapeur.

### Description des modes d'exécution

Les modes de réalisation ci-après sont décrits en relation avec un navire comportant une double coque formant une structure porteuse dans laquelle sont agencées une pluralité de cuves étanches et thermiquement isolantes. Dans une telle structure porteuse, les cuves présentent par exemple une géométrie polyédrique, par exemple de forme prismatique.

De telles cuves étanches et thermiquement isolantes sont prévues par exemple pour le transport de gaz liquéfié. Le gaz liquéfié est stocké et transporté dans de telles cuves à une température basse ce qui nécessite des parois de cuve thermiquement isolantes afin de maintenir le gaz liquéfié à cette température.

De telles cuves étanches et thermiquement isolantes comportent aussi une barrière isolante ancrée sur la double coque de navire et portant au moins une membrane étanche. À titre d'exemple, de telles cuves peuvent être réalisées selon les technologies commercialisées sous les marques Mark III^{®} ou NO96^{®} de la déposante, ou autres.

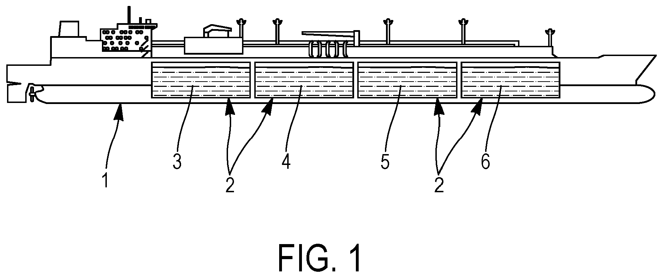

La figure 1 illustre un navire 1 comportant quatre cuves 2 étanches et thermiquement isolantes. Les quatre cuves 2 peuvent présenter des états de remplissage identiques ou différents.

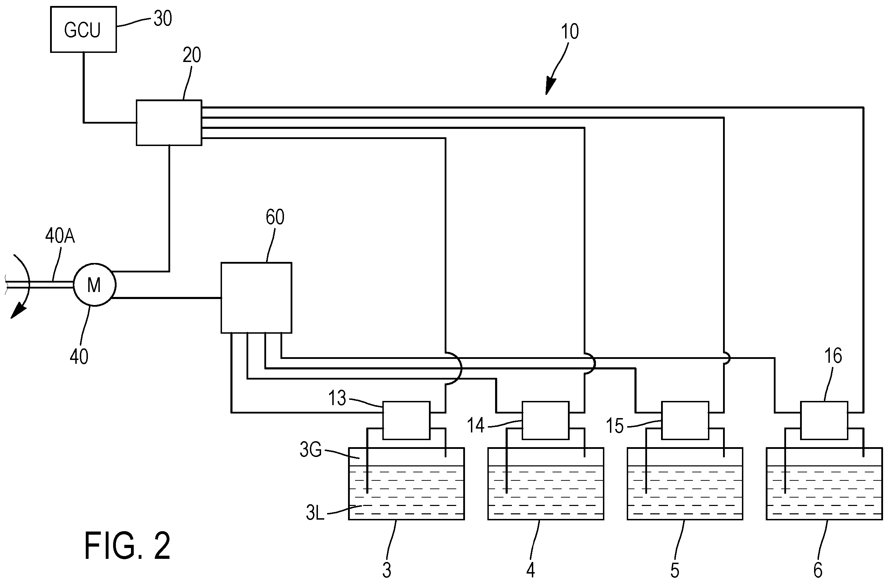

La figure 2 est un diagramme-blocs représentant schématiquement les quatre cuves 3, 4, 5, 6 du navire de la figure 1. Comme représenté sur la figure 2, le navire 1 est en outre pourvu d'un système de traitement de phase vapeur 10, d'un moteur 40 et d'une unité de combustion de gaz (« Gas Combustion Unit » ou GCU en anglais) 30.

Le moteur 40 fournit la puissance nécessaire à la propulsion du navire 1 ; il peut, en variante, fournir à la fois ladite puissance nécessaire à la propulsion du navire 1 et de la puissance nécessaire à l'alimentation électrique d'autres équipements du navire 1 (dénommée couramment « Hotel Load » en anglais). De façon connue en soi, le moteur 40 est apte à consommer du gaz en phase vapeur, pouvant provenir du gaz d'évaporation (« Boil-Off Gas » ou BOG en anglais, dénommé dans la suite BOG par commodité) sortant des cuves 3, 4, 5, 6 ou pouvant provenir d'un réchauffeur 60 destiné à vaporiser du gaz liquéfié extrait des cuves. Un tel moteur 40 est connu en tant que tel et n'est donc pas décrit en détail ici.

Toujours de façon connue en soi, la GCU 30 est apte à brûler un éventuel excédent de BOG qui ne pourrait pas être consommé par le moteur 40. Une telle GCU 30 est connue en tant que telle et n'est donc pas décrite en détail ici.

Le système de traitement de phase vapeur 10 est apte à envoyer du BOG sortant de chaque cuve 3, 4, 5, 6 vers le moteur 40 ou vers la GCU 30, selon le cas. Pour ce faire, le système de traitement de phase vapeur 10 comprend respectivement un sous-système de traitement de phase vapeur 13, 14, 15, 16 pour chacune des cuves 3, 4, 5, 6, et une unité de distribution de BOG 20 communiquant avec ces sous-systèmes 13, 14, 15, 16 de façon à permettre d'envoyer le BOG vers le moteur 40 ou la GCU 30, selon le cas. De tels systèmes et sous-systèmes de traitement de phase vapeur sont connus en tant que tels et ne sont donc pas décrits en détail ici.

Toujours de façon connue en soi, chaque sous-système 13, 14, 15, 16 est en outre apte à extraire une portion de la phase liquide contenue dans la cuve 3, 4, 5, 6 correspondante et à envoyer cette portion vers le réchauffeur 60 afin de l'évaporer lorsque cela est souhaité.

Bien qu'on ait représenté un navire 1 pourvu de quatre cuves, il est bien entendu que le navire 1 peut être pourvu qu'un nombre différent de cuves, notamment une unique cuve ou bien un nombre quelconque de cuves.

Dans la suite et par commodité, on va décrire le procédé d'aide à la gestion 300 en se référant à la cuve 3, étant entendu que le procédé d'aide à la gestion 300 peut être mis en œuvre simultanément pour plusieurs ou chacune des cuves 3, 4, 5, 6.

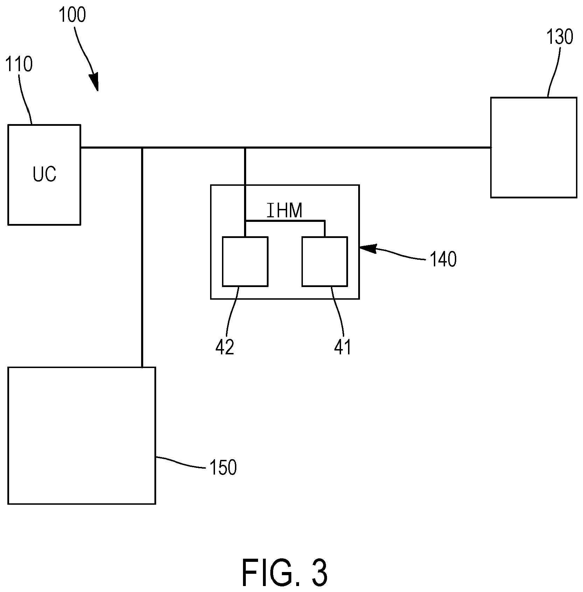

La figure 3 illustre un exemple de système d'aide à la gestion 100 embarqué sur le navire 1. Ce système d'aide à la gestion 100 comporte une unité centrale 110 connectée à une interface de communication 130, une interface homme-machine 140 et une base de données 150.

L'interface de communication 130 permet à l'unité centrale 110 de communiquer avec des dispositifs distants par exemple pour obtenir des données météorologiques, des données de position du navire ou autre.

L'interface homme machine 140 comporte un moyen d'affichage 41. Le moyen d'affichage 41 permet à d'afficher à un utilisateur un ou plusieurs scénarios de gestion de cuve 50 comme on va le détailler plus loin.

L'interface homme-machine 140 comporte en outre un moyen d'acquisition 42 permettant à l'utilisateur de fournir manuellement des grandeurs à l'unité centrale 110 comme on va le détailler plus loin.

Le système d'aide à la gestion 100 comporte en outre une base de données 150. Cette base de données 150 est utilisable pour stocker des modèles, notamment des modèles 61, 62, 63 comme on va le détailler plus loin.

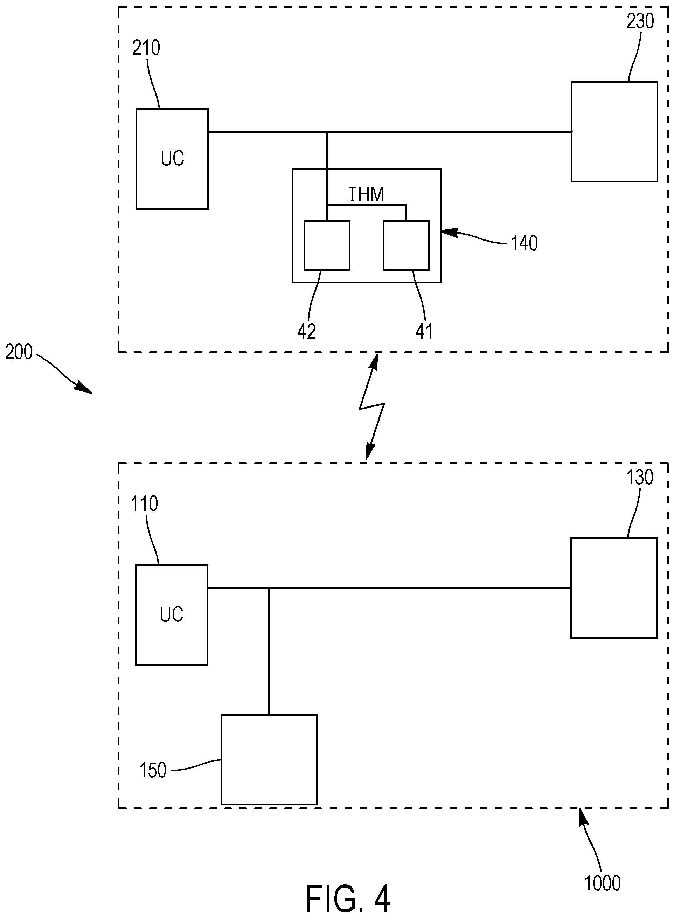

La figure 4 illustre un exemple de système d'aide à la gestion 200 situé à terre et communiquant avec le navire 1. Le navire 1 comporte une unité centrale 210, l'interface homme-machine 140 et une interface de communication 230. L'unité centrale 110, l'interface de communication 130 et la base de données 150 sont quant à elles situées dans une station à terre 1000. Le fonctionnement du système d'aide à la gestion 200 est similaire au fonctionnement du système d'aide à la gestion 100 et ne se différentie que par l'envoi des résultats des calculs effectués par l'unité centrale 110 située à terre à l'interface homme-machine 140 embarquée à bord du navire 1 par l'intermédiaire des interfaces de communication 130 et 230. À titre d'exemple, les interfaces de communication 130 et 230 peuvent utiliser une transmission de données par radiofréquence terrestre ou satellite.

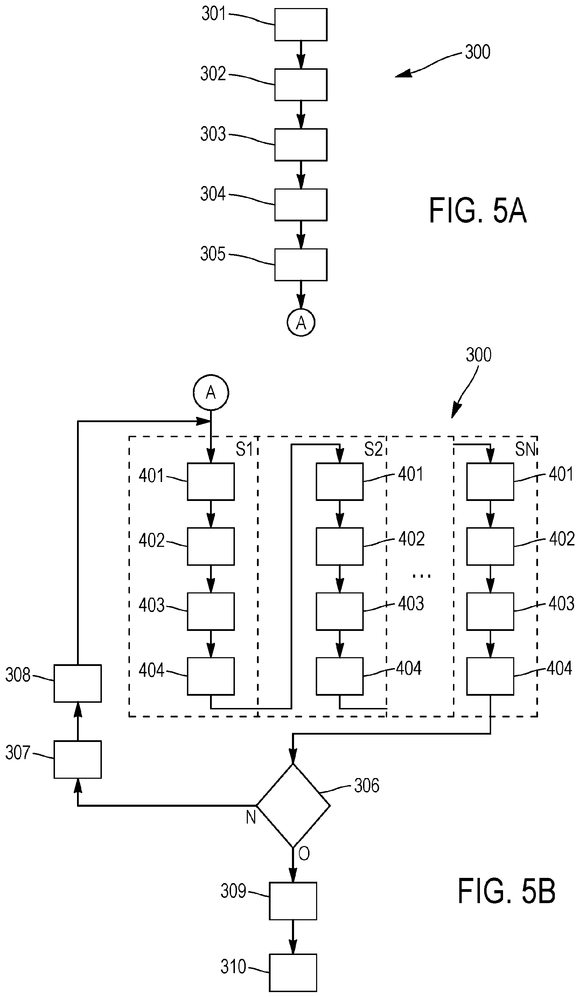

En se référant aux figures 5A à 9, on va maintenant décrire un procédé 300 d'aide à la gestion du navire 1, qui peut être mis en œuvre à l'aide du système d'aide à la gestion 100 ou 200.

Le procédé 300 comprend une première étape 301 consistant à fournir un état initial de la cuve 3. Cet état initial comprend une pression initiale de la phase gazeuse 3G contenue dans la cuve 3 et une température initiale de la phase liquide 3L contenue dans la cuve 3. Ces informations sont par exemple entrées par un utilisateur à l'aide du moyen d'acquisition 42.

De préférence, l'état initial comprend en outre une composition initiale du gaz liquéfié contenu dans la cuve 3. Cette composition initiale est en général indiquée par le fournisseur du gaz liquéfié lors de son chargement dans la cuve 3. Elle peut par exemple être entrée par l'utilisateur à l'aide du moyen d'acquisition 42.

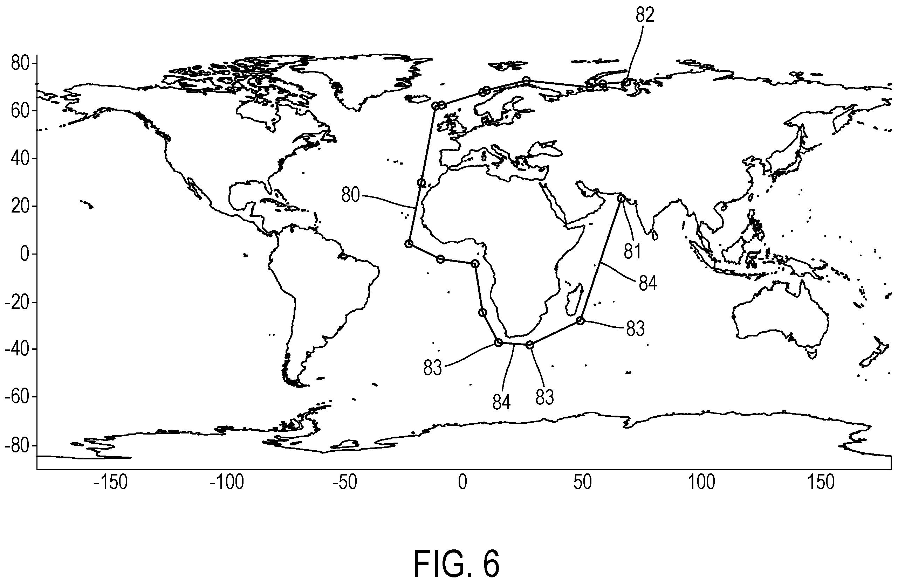

Le procédé 300 comprend en outre une étape 302 consistant à fournir un trajet prévisionnel 80 du navire 1. On a représenté sur la figure 6 à titre d'illustration un exemple de trajet prévisionnel 80. Comme représenté sur cette figure, le trajet prévisionnel 80 est défini par un point de départ 81, un point de destination 82, et une pluralité de points de cheminement (ou points de navigation) (« waypoints » en anglais) 83 par lesquels il est prévu de faire passer le navire 1. Les points 81, 82, 83 sont par exemple entrés par l'utilisateur à l'aide du moyen d'acquisition 42. Les points 81, 82, 83 sont définis par leurs coordonnées géographiques de façon connue en soi.

Chaque paire de points de cheminement 83 consécutifs définissent ensemble une étape de trajet 84. Le trajet prévisionnel 80 peut en outre être défini par un cap à suivre par le navire 1 le long des étapes de trajet 84.

Le procédé 300 comprend en outre une étape 303 consistant à déterminer au moins un paramètre environnemental du navire 1 le long du trajet prévisionnel 80 à partir de prévisions météorologiques. Concrètement, à l'aide de l'interface de communication 130, l'unité centrale 110 acquiert des prévisions météorologiques fournies par un fournisseur de prévisions météorologiques, et détermine le au moins un paramètre environnemental à partir des prévisions météorologiques et du trajet prévisionnel 80. Le paramètre environnemental comprend au moins l'un parmi une direction du courant, une vitesse du courant, une vitesse du vent, une direction du vent, une hauteur moyenne des vagues, une direction des vagues, et une période des vagues, et de préférence plusieurs voire la totalité de ces paramètres. Il est à noter que certains des paramètres environnementaux peuvent être fournis directement par le fournisseur de prévisions météorologiques, tandis que d'autres peuvent être estimés par l'unité centrale 110 en appliquant un modèle aux prévisions météorologiques.

Le procédé 300 comprend en outre une étape 304 consistant à déterminer une courbe de vitesse du navire 1 le long du trajet prévisionnel 80. Dans un mode d'exécution simplifié, la courbe de vitesse peut simplement être fournie comme donnée d'entrée, par exemple par l'utilisateur à l'aide du moyen d'acquisition 41.

Le procédé 300 comprend en outre une étape 305 consistant à générer une pluralité de scénarios de gestion de cuve 50.

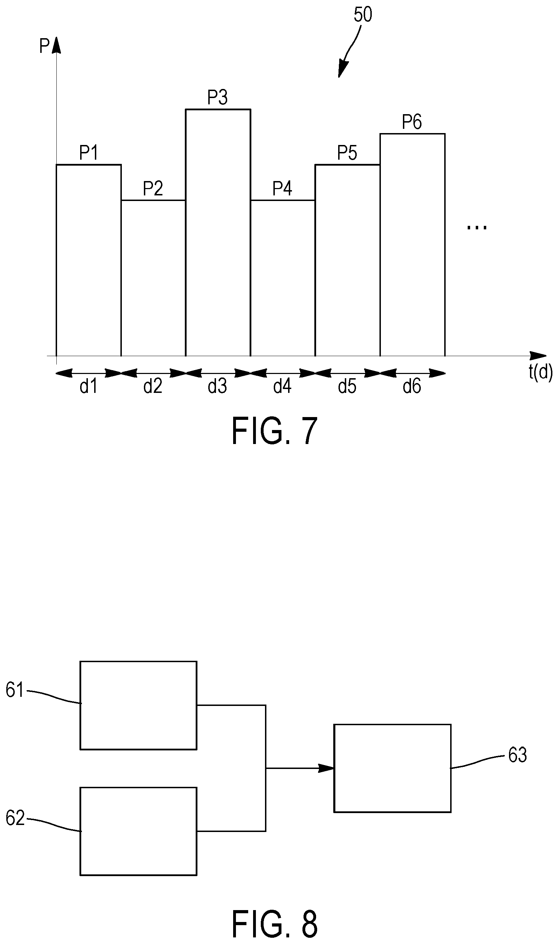

La figure 7 est un graphique représentant à titre d'illustration un exemple de scénario de gestion de cuve 50. Comme représenté sur cette figure, un scénario de gestion de cuve 50 donné définit une évolution de la pression P de la phase gazeuse 3G contenue de la cuve 3 en fonction du temps t, pendant ledit trajet prévisionnel. Dans un mode de réalisation préféré, le trajet prévisionnel 80 étant divisé en intervalles de temps consécutifs d1, d2, d3, d4, d5, d6, .... , le scénario de gestion de cuve 50 définit des valeurs moyennes P1, P2, P3, P4, P5, P6, ... de la pression P sur les intervalles de temps d1, d2, d3, d4, d5, d6, .... Les intervalles de temps d1, d2, d3, d4, d5, d6, ... peuvent notamment être chacun égal à un jour.

Les scénarios de gestion de cuve 50 peuvent par exemple être générés aléatoirement à l'étape 305.

Après l'étape 305, le procédé 300 passe à l'évaluation des scénarios de gestion de cuve 50 (repère A sur les figures 5A et 5B).

Selon un mode d'exécution préféré qui va être décrit plus en détail dans la suite, le procédé 300 met en œuvre un algorithme évolutionnaire utilisant comme fonction objectif une fonction de coût qui dépend au moins d'une quantité totale de BOG générée dans la cuve 3 le long du trajet prévisionnel 80. Dans le cadre de cet algorithme évolutionnaire, de façon connue en soi, les scénarios de gestion de cuve 50 sont régénérés itérativement une pluralité de fois, chaque nouvelle génération de scénarios de gestion de cuve 50 étant générée à partir d'un certain nombre de scénarios de gestion de cuve 50 de la génération précédente qui minimisent le mieux la fonction de coût.

La figure 8 est un diagramme-blocs qui illustre, afin de faciliter la compréhension de la description qui va suivre, des modèles 61, 62, 63 qui sont mis en œuvre afin d'évaluer la fonction de coût. Ces modèles 61, 62, 63 peuvent être stockés dans la base de données 150 du système d'aide à la gestion 100.

Un premier modèle 61, que l'on appellera dans la suite « modèle moteur 61 », est apte à estimer une puissance requise en sortie du moteur 40, plus précisément une puissance mécanique requise au niveau d'un arbre de sortie 40A du moteur 40 (voir figure 2). Cette puissance mécanique peut être la seule puissance nécessaire à la propulsion du navire 1. Elle peut, en alternative, être la somme de la puissance nécessaire à la propulsion du navire 1 et de la puissance nécessaire à l'alimentation électrique d'autres équipements du navire 1 (dénommée couramment « Hotel Load » en anglais). En tout état de cause, le modèle moteur 61 est apte à estimer la puissance requise en sortie du moteur 40 en fonction d'une consigne de vitesse du navire 1, du au moins un paramètre environnemental, et éventuellement du cap du navire 1.

Selon un mode d'exécution particulier, le modèle moteur 61 est un modèle statistique entraîné par une méthode d'apprentissage automatique supervisé. Ce modèle statistique est entraîné à partir d'un ensemble de données d'essais, l'ensemble de données d'essais pouvant être obtenu à partir d'essais de navigation consistant à faire naviguer un navire et à mesurer :
- d'une part, une vitesse du navire et au moins un paramètre environnemental choisi parmi la hauteur des vagues, la période des vagues, l'angle entre la direction des vagues et le cap du navire, la vitesse du vent, l'angle entre la direction du vent et le cap du navire ;
- d'autre part, une puissance en sortie du moteur du navire nécessaire pour maintenir la vitesse du navire.

Un deuxième modèle 62, que l'on appellera dans la suite « modèle de cuve 62 », est apte à estimer une quantité de BOG générée dans la cuve 3. Le modèle de cuve 62 estime la quantité de BOG générée dans la cuve en estimant séparément :
- une première quantité de BOG générée dans la cuve 3 en fonction de la pression courante P de la phase gazeuse 3G contenue dans la cuve 3 et de la température courante T de la phase liquide 3L contenue dans la cuve 3 ; et
- une deuxième quantité de BOG générée dans la cuve 3 en fonction de la pression courante P de la phase gazeuse 3G et du au moins un paramètre environnemental,
puis en additionnant ces deux quantités de BOG.

La première quantité de BOG reflète la génération de BOG liée à la coexistence de la phase liquide 3L et de la phase gazeuse 3G. Elle peut être estimée par un modèle thermodynamique connu en soi, par exemple un modèle de Hertz-Knudsen.

La deuxième quantité de BOG reflète la génération supplémentaire de BOG dans la cuve 3 du fait de l'agitation de la phase liquide 3L due aux mouvements subis par le navire 1.

Selon un mode d'exécution particulier, la deuxième quantité de BOG est estimée par un modèle statistique entraîné par une méthode d'apprentissage automatique supervisé. Ce modèle statistique est entraîné à partir d'un ensemble de données d'essais, l'ensemble de données d'essais pouvant être obtenu à partir d'essais de navigation consistant à faire naviguer un navire et à mesurer :
- d'une part, une pression de la phase gazeuse contenue dans la cuve et une température de la phase liquide contenue dans la cuve ; et
- d'autre part, une différence entre la quantité de BOG effectivement générée dans la cuve du navire et une quantité estimée de BOG estimée par un modèle thermodynamique.

En outre, si, comme on l'a mentionné ci-dessus, une composition initiale du gaz liquéfié contenu dans la cuve 3 est fournie à l'étape 301, le modèle de cuve 62 peut en outre estimer la composition du BOG généré dans la cuve 3. Dans ce cas, le modèle estimant la première quantité de BOG et le modèle estimant la deuxième quantité de BOG estiment chacun la composition du BOG généré dans la cuve 3.

Un troisième modèle 63, que l'on appellera dans la suite « modèle de flux 63 », est apte à estimer une quantité de gaz à extraire de la cuve 3 par le sous-système de traitement de phase vapeur 13 et une quantité de BOG à brûler dans la GCU 30. Plus concrètement, le modèle de flux 63 estime, à partir de la puissance estimée par le modèle 61, une quantité de BOG à fournir au moteur 40, et compare cette quantité de BOG à fournir au moteur 40 avec la quantité de BOG générée dans la cuve 3 estimée par le modèle de cuve 62. Si la quantité de BOG à fournir au moteur 40 est inférieure à la quantité de BOG générée dans la cuve 3, le modèle de flux 63 détermine que la différence entre ces deux quantités est à brûler dans la GCU 30. Inversement, si la quantité de BOG à fournir au moteur 40 est supérieure à la quantité de BOG générée dans la cuve 3, le modèle de flux 63 détermine que la différence entre ces deux quantités est à extraire de la cuve 3 par le sous-système de traitement de phase vapeur 13.

Les modèles 61, 62, 63 sont mis en œuvre itérativement, avec un pas de temps très faible par rapport à la durée des intervalles d1, d2, ..., de façon à estimer à chaque itération la pression P de la phase gazeuse 3G, la température T de la phase liquide 3L, la quantité de BOG générée par la cuve 3 (et le cas échéant la composition du BOG généré par la cuve 3), et la quantité de BOG à fournir au moteur 40 à la GCU 30.

En revenant à la figure 5B, on va maintenant décrire les étapes permettant de parvenir à l'évaluation de la fonction de coût. N étant le nombre de scénarios de gestion de cuve 50 générés à l'étape 305, le procédé 300 réalise N évaluations S1, S2, ..., SN pour chacun des scénarios de gestion de cuve 50. Bien que le diagramme de la figure 5B représente les évaluations S1, S2, ..., SN comme étant effectuées séquentiellement, celles-ci peuvent éventuellement être effectuées en parallèle. Chaque évaluation S1, S2, ..., SN comprend des étapes 401, 402, 403, 404 qui sont détaillées ci-après.

À l'étape 401, à partir de la courbe de vitesse du navire 1 déterminée à l'étape 304 et du au moins un paramètre environnemental déterminé à l'étape 303, une courbe de puissance requise en sortie du moteur 40 le long du trajet prévisionnel 80 est estimée à l'aide du modèle moteur 61.

À l'étape 402, une courbe de quantité de BOG générée dans la cuve 3 le long du trajet prévisionnel 80 est estimée à l'aide du modèle de cuve 62.

À l'étape 403, à partir de la courbe de puissance requise en sortie du moteur 40 estimée à l'étape 401 et de la courbe de quantité de BOG générée dans la cuve 3 estimée à l'étape 402, une courbe de quantité de gaz à extraire de la cuve 3 et une courbe de quantité de BOG à brûler dans la GCU 30 sont estimées à l'aide du modèle de flux 63.

Après les étapes 401 à 403, dans une étape 404, une fonction de coût est calculée. Plus concrètement, la fonction de coût est un nombre réel qui est calculé à partir des estimations réalisées aux étapes 401 à 403, et qui quantifie l'acceptabilité du scénario de gestion de cuve 50 en question.

Dans un mode d'exécution simple, la fonction de coût dépend seulement de la quantité totale de BOG générée dans la cuve 3 le long du trajet prévisionnel 80. Toutefois, il est préférable que la fonction de coût dépende en outre d'autres grandeurs ou critères.

Dans un mode d'exécution préféré, la fonction de coût dépend en outre :
- d'une différence entre la pression P de la phase gazeuse contenue dans la cuve 3 à la fin du trajet prévisionnel 80 et pression de déchargement exigée par un terminal de déchargement situé au point de destination 82 ;
- et/ou d'une différence entre la température T de la phase liquide contenue dans la cuve 3 à la fin du dudit trajet prévisionnel 80 et une température de déchargement exigée par un terminal de déchargement situé au point de destination 82 ;
- et de préférence à la fois de ces deux différences. De cette manière, un scénario de gestion de cuve 50 est considéré comme d'autant plus acceptable qu'il permet de d'arriver au terminal de déchargement situé au point de destination 82 avec une pression de déchargement et une température de déchargement proches de celles exigées par le terminal de déchargement.

En complément ou en alternative, la fonction de coût peut en outre dépendre du respect, par le scénario de gestion de cuve 50, de certains ou de tous des critères suivants :
- la pression P de la phase gazeuse contenue dans la cuve 3 reste inférieure à une pression maximale de sécurité ; cette pression maximale de sécurité peut être une valeur fixe définie à l'avance, ou bien une valeur variable qui dépend de conditions environnementales rencontrées par le navire 1 le long du trajet prévisionnel 80, et qui peut par exemple être plus basse en cas de tempête ou autres conditions de navigation potentiellement dangereuses ;
- la pression P de la phase gazeuse contenue dans la cuve 3 reste supérieure à une pression minimale ; cette pression minimale peut être une valeur fixe définie à l'avance, ou bien une valeur variable qui dépend de la quantité de BOG demandée par le moteur 40, telle qu'estimée par le modèle de flux 63 ;
- le débit de BOG à travers le système de traitement de phase vapeur 10 reste inférieur à une valeur seuil.

Comme on l'a mentionné précédemment, chacune des étapes 401 à 404 est effectuée dans le cadre de chacune des évaluations S1, S2, ..., SN des scénarios de gestion de cuve 50.

Après les évaluations S1, S2, ..., SN, le procédé 300 passe à une étape 306 consistant à vérifier si un critère d'arrêt est vérifié. Dans un mode d'exécution, le critère d'arrêt est un critère de temps de calcul. Autrement dit, le critère d'arrêt est considéré comme vérifié si un temps de calcul défini à l'avance est atteint ou dépassé. En alternative, le critère d'arrêt peut être un critère de nombre d'itérations.

En tout état de cause, si le critère d'arrêt n'est pas vérifié (repère « N » en 306 sur la figure 5B), le procédé 300 passe à une étape 307 consistant à sélectionner k scénarios de gestion de cuve 50 parmi les N scénarios de gestion de cuve 50 évalués pendant les évaluations S1, S2, ..., SN, où k < N. Les k scénarios de gestion de cuve 50 sélectionnés à l'étape 307 sont ceux qui minimisent le mieux la fonction de coût calculée à l'étape 404. Dans une variante, k est un nombre fixé à l'avance. Dans une autre variante, k n'est pas fixé à l'avance, et les k scénarios de gestion de cuve 50 sélectionnés sont ceux pour lesquels la fonction de coût calculée à l'étape 404 est inférieure à un seuil.

Après l'étape 307, le procédé 300 passe à une étape 308 consistant à générer N nouveaux scénarios de gestion de cuve 50 à partir des k scénarios de gestion de cuve 50 sélectionnés à l'étape 307.

Comme on l'a mentionné ci-dessus, dans ce mode d'exécution, le procédé 300 met en œuvre un algorithme évolutionnaire utilisant comme fonction objectif la fonction de coût calculée à l'étape 404. Dans un mode d'exécution particulier, l'algorithme évolutionnaire est un algorithme génétique. Les méthodes d'optimisation utilisant un algorithme évolutionnaire sont bien connues en tant que telles. L'étape 305 consiste alors à initialiser la population considérée par l'algorithme évolutionnaire en générant aléatoirement N scénarios de gestion de cuve 50, et l'étape 308 consiste à générer N nouveaux scénarios de gestion de cuve 50 par croisement et mutation des scénarios de gestion de cuve sélectionnés à l'étape 307.

Si au contraire le critère d'arrêt est vérifié (repère « O » en 306 sur la figure 5B), le procédé 300 passe à une étape 309 consistant à sélectionner p scénarios de gestion de cuve 50 parmi les N scénarios de gestion de cuve 50 évalués pendant les évaluations S1, S2, ..., SN, où 1 ≤ p < N. Les p scénarios de gestion de cuve 50 sélectionnés à l'étape 307 sont ceux qui minimisent le mieux la fonction de coût calculée à l'étape 404. Dans une variante, p est un nombre fixé à l'avance. Dans une autre variante, p n'est pas fixé à l'avance, et les p scénarios de gestion de cuve sélectionnés sont ceux pour lesquels la fonction de coût calculée à l'étape 404 est inférieure à un seuil.

Après l'étape 309, le procédé 300 passe à une étape 310 consistant à afficher à l'utilisateur les scénarios de gestion de cuve sélectionnés à l'étape 309, par exemple sur le moyen d'affichage 41.

Dans un mode d'exécution alternatif très simplifié, un seul scénario de gestion de cuve 50 est généré à l'étape 305. Les étapes 401 à 404 sont alors effectuées pour ce seul scénario de gestion de cuve 50, et les étapes 306, 307, 308 sont omises. À l'étape 309, il est déterminé, en fonction de la fonction de coût calculée à l'étape 404, si le scénario de gestion de cuve 50 est acceptable. Dans l'affirmative, ce scénario de gestion de cuve 50 est affiché à l'étape 310.

Dans un autre mode d'exécution alternatif simplifié, une pluralité de scénarios de gestion de cuve 50 sont générés à l'étape 308, mais les étapes 306, 307, 308 sont omises.

Les étapes du procédé 300 peuvent être réitérées à intervalles fixes et/ou à réception de nouvelles prévisions météorologiques par l'interface de communication 130. En complément ou en alternative, les étapes du procédé 300 peuvent être réitérées sur commande de l'utilisateur.

En tout état de cause, le procédé 300 conduit, à l'étape 310, à afficher à l'utilisateur, par exemple sur le moyen d'affichage 41, au moins un scénario de gestion de cuve 50, en fonction de la fonction de coût calculée à l'étape 404. Le procédé 300 permet ainsi de proposer une aide à la décision à l'utilisateur.

Comme on l'a mentionné ci-dessus, un scénario de gestion de cuve 50 donné peut définir des valeurs moyennes P1, P2, P3, P4, P5, P6, ... de la pression P sur des intervalles de temps consécutifs d1, d2, d3, d4, d5, d6, .... Dans un mode d'exécution préféré, après l'étape 309 et avant l'étape 310, le ou les scénarios de gestion de cuve 50 sélectionnés à l'étape peuvent être post-traités de façon à afficher en outre à l'utilisateur des valeurs minimales et maximales de la pression P sur les intervalles de temps consécutifs d1, d2, d3, d4, d5, d6, ... .

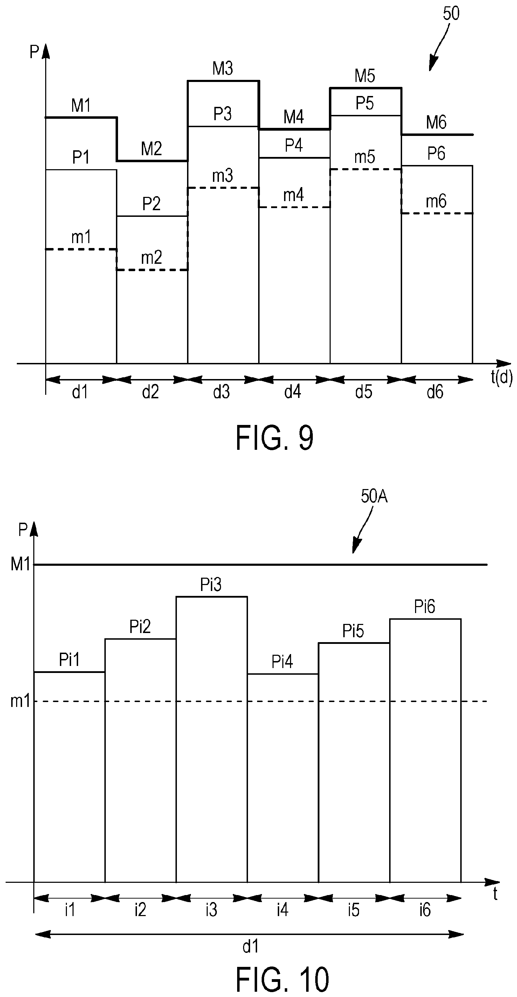

La figure 9 est un graphique représentant à titre d'illustration un exemple de scénario de gestion de cuve 50 ainsi post-traité. Comme représenté sur cette figure, le scénario de gestion de cuve 50 définit sur l'intervalle d1, outre la valeur moyenne P1, une valeur maximale M1 et une valeur minimale m1, la pression P ne pouvant ni être supérieure à la valeur maximale M1 ni être inférieure à la valeur minimale m1. De façon analogue, sur chaque intervalle d2, d3, d4, d5, d6, ..., le scénario de gestion de cuve 50 définit respectivement des valeurs maximales M2, M3, M4, M5, M6, ... et des valeurs minimales m2, m3, m4, m5, m6, ....

La valeur maximale M1 est calculée en fonction de la valeur moyenne P1 et en fonction d'une ou plusieurs contraintes relatives à la cuve 3. Les contraintes relatives à la cuve 3 peuvent inclure des contraintes de sécurité de la cuve 3, telles que la pression maximale de sécurité de la cuve. Toutes ou certaines des contraintes relatives à la cuve 3 peuvent être entrées par l'utilisateur à l'aide du moyen d'acquisition 42.

Les valeurs maximales M2 à M6 sont calculées de façon analogue, en fonction des valeurs moyennes P2 à P6 et d'une ou plusieurs contraintes relatives à la cuve 3.

La valeur minimale m1 est calculée en fonction de la valeur moyenne P1 et de la quantité de gaz à extraire de la cuve 3 pendant l'intervalle d1 estimée à l'étape 403 à l'aide du modèle de flux 63.

Les valeurs minimales m2 à m6 sont calculées de façon analogue, en fonction des valeurs moyennes P2 à P6 et des quantités de gaz à extraire de la cuve 3 pendant les intervalles d2 à d6.

Dans une variante d'exécution simple, le ou les scénarios de gestion de cuve 50 ainsi post-traités peuvent simplement être affichés à l'utilisateur, c'est-à-dire affichés ensemble avec les valeurs minimales m1 à m6 et les valeurs maximales M1 à M6 correspondantes. Ceci permet de proposer à l'utilisateur une aide supplémentaire à la décision, en lui affichant en outre une plage de valeurs, c'est-à-dire l'intervalle [m1, M1], [m2, M2], ...dans laquelle la pression P peut être autorisée à varier dans pendant l'intervalle d1, d2, ....

En variante, ou bien seules les valeurs maximales M1 à M6, ou bien seules les valeurs minimales m1 à m6 peuvent être calculées puis affichées.

Dans une variante particulièrement préférée, le ou les scénarios de gestion de cuve 50 ainsi post-traités peuvent en outre passer, avant l'étape 310, par une étape d'optimisation supplémentaire visant à déterminer des valeurs optimales de la pression P sur des sous-intervalles des intervalles d1, d2, ....

La figure 10 est un graphique représentant à titre d'illustration un exemple de scénario de gestion de cuve 50A ainsi optimisé. Comme représenté sur cette figure, l'intervalle de temps d1 est subdivisé en plusieurs sous-intervalles de temps consécutifs i1, i2, i3, i4, i5, i6 .... Les intervalles de temps i1, i2, i3, i4, i5, i6 ... peuvent notamment être chacun égal à une heure. Outre la valeur moyenne P1 et les valeurs minimale m1 et maximale M1, le scénario de gestion de cuve 50A définit des valeurs moyennes Pi1, Pi2, Pi3, Pi4, Pi5, Pi6 sur chacun des sous-intervalles de temps i1, i2, i3, i4, i5, i6. De même, et bien que cela ne soit pas représenté sur la figure 10 par souci de concision, les intervalles de temps d2, d3, d4, d5, d6, ... sont eux aussi subdivisés en plusieurs sous-intervalles de temps consécutifs, une valeur moyenne de la pression P étant définie sur chacun de ces sous-intervalles.

Les valeurs moyennes Pi1, Pi2, ... sont déterminées par un algorithme évolutionnaire utilisant comme fonction objectif une fonction de coût qui dépend au moins d'une quantité totale de BOG générée dans la cuve 3 pendant l'intervalle i1 et du respect des critères suivants :
- la pression P de la phase gazeuse contenue dans la cuve 3 reste inférieure à la valeur maximale M1 ;
- la pression P de la phase gazeuse contenue dans la cuve 3 reste supérieure la valeur minimale m1 ;
- le débit de BOG à travers le système de traitement de phase vapeur 10 reste inférieur à une valeur seuil.

Cette détermination s'effectue par des étapes analogues aux étapes 401 à 404 à 306 à 308, qui ne sont donc pas décrites en détail à nouveau. Le ou les scénarios de gestion de cuve 50A sont ensuite affichés à l'utilisateur.

Comme on l'a mentionné ci-dessus, la courbe de vitesse peut simplement être fournie comme donnée d'entrée, par exemple par l'utilisateur à l'aide du moyen d'acquisition 41, à l'étape 304. Toutefois, il est préférable, à l'étape 304, que la courbe de vitesse soit déterminée par un algorithme évolutionnaire utilisant une fonction objectif qui dépend d'une quantité totale de BOG générée dans la cuve 3 le long du trajet prévisionnel 80 et d'une différence entre une heure requise d'arrivée à destination du navire 1 et une heure estimée d'arrivée à destination du navire 1. L'heure requise d'arrivée à destination du navire 1 peut être entrée par l'utilisateur à l'aide du moyen d'acquisition 42.

Dans le cadre de cet algorithme évolutionnaire, de façon connue en soi, des scénarios de gestion de vitesse 550 sont générés itérativement une pluralité de fois, chaque nouvelle génération de scénarios de gestion de vitesse 550 étant générée à partir d'un certain nombre de scénarios de gestion de vitesse 550 de la génération précédente qui minimisent le mieux la fonction objectif.

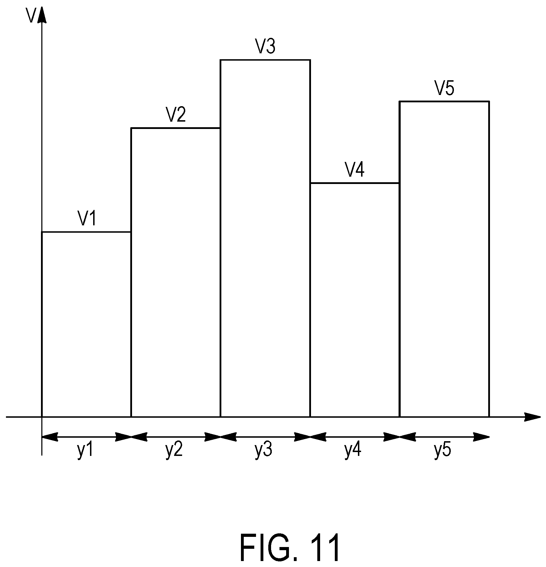

La figure 11 est un graphique représentant à titre d'illustration un exemple de scénario de gestion de vitesse 550. Comme représenté sur cette figure, le trajet prévisionnel 80 étant divisé en intervalles consécutifs de distance parcourue y1, y2, y3, y4, y5, ..., un scénario de gestion de vitesse 550 donné définit une évolution de la vitesse V du navire 1 en définissant des valeurs moyennes V1, V2, V3, V4, V5, ... de la vitesse V sur chacun des intervalles consécutifs de distance parcourue y1, y2, y3, y4, y5, .... Les intervalles de distance parcourue y1, y2, y3, y4, y5, ... peuvent, de façon avantageuse, être définis par référence aux points 81, 82, 83 du trajet prévisionnel 80.

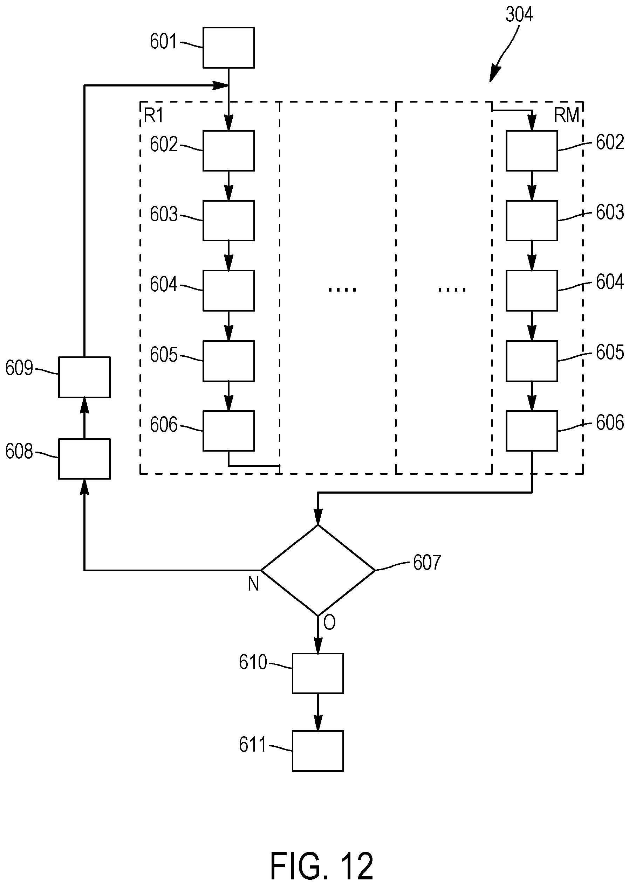

En référence à la figure 12, on va maintenant décrire les étapes de mise en œuvre de l'algorithme évolutionnaire.

Lors d'une étape 601, une pluralité de scénarios de gestion de vitesse 550 sont générés, par exemple aléatoirement.

Après l'étape 601, M étant le nombre de scénarios de gestion de vitesse 550 générés à l'étape 601, M évaluations R1, R2, ..., RM sont réalisées pour chacun des scénarios de gestion de vitesse 550. Bien que le diagramme de la figure 12 représente les évaluations R1, R2, ..., RM comme étant effectuées séquentiellement, celles-ci peuvent éventuellement être effectuées en parallèle. Chaque évaluation R1, R2, ..., RM comprend des étapes 602, 603, 604, 605, 606 qui sont détaillées ci-après.

À l'étape 602, une courbe de vitesse effective du navire 1 est estimée à l'aide d'un modèle hydrodynamique du navire 1.

À l'étape 603, une trajectoire effective du navire 1 est estimée à partir de la courbe de vitesse effective estimée à l'étape 602 et à l'aide d'un modèle de courants océaniques.

À l'étape 604, on détermine le au moins un paramètre environnemental du navire 1 le long de la trajectoire effective du navire 1 à partir de prévisions météorologiques. Concrètement, de façon analogue à l'étape 303, à l'aide de l'interface de communication 130, l'unité centrale 110 acquiert des prévisions météorologiques fournies par un fournisseur de prévisions météorologiques, et détermine le au moins un paramètre environnemental à partir des prévisions météorologiques et de la trajectoire effective du navire 1 estimée à l'étape 603.

À l'étape 605, une courbe de quantité de BOG générée dans la cuve 3 le long de la trajectoire effective du navire 1 est estimée à l'aide du modèle de cuve 62.

Après les étapes 601 à 605, dans une étape 606, la fonction objectif est calculée. La fonction objectif est un nombre réel qui quantifie l'acceptabilité du scénario de gestion de vitesse 550. Comme on l'a mentionné ci-dessus, la fonction objectif dépend d'une quantité totale de BOG générée dans la cuve 3 le long du trajet prévisionnel 80 et d'une différence entre une heure requise d'arrivée à destination du navire 1 et une heure estimée d'arrivée à destination du navire 1.

Après les évaluations R1, R2, ..., RM, on passe à une étape 607 consistant à vérifier si un critère d'arrêt est vérifié. Dans un mode d'exécution, le critère d'arrêt est un critère de temps de calcul. Autrement dit, le critère d'arrêt est considéré comme vérifié si un temps de calcul défini à l'avance est atteint ou dépassé. En alternative, le critère d'arrêt peut être un critère de nombre d'itérations.

En tout état de cause, si le critère d'arrêt n'est pas vérifié (repère « N » en 607 sur la figure 12), on passe à une étape 608 consistant à sélectionner k' scénarios de gestion de vitesse 550 parmi les M scénarios de gestion de vitesse 550 évalués pendant les évaluations R1, R2, ..., RM, où k' < M. Les k' scénarios de gestion de vitesse 550 sélectionnés à l'étape 608 sont ceux qui minimisent le mieux la fonction objectif calculée à l'étape 606. Dans une variante, k' est un nombre fixé à l'avance. Dans une autre variante, k n'est pas fixé à l'avance, et les k' scénarios de gestion de vitesse 550 sélectionnés sont ceux pour lesquels la fonction objectif calculée à l'étape 608 est inférieure à un seuil.

Après l'étape 608, on passe à une étape 609 consistant à générer M nouveaux scénarios de gestion de cuve à partir des k' scénarios de gestion de vitesse 550 sélectionnés à l'étape 608.

Dans un mode d'exécution particulier, l'algorithme évolutionnaire est un algorithme génétique. L'étape 601 consiste alors à initialiser la population considérée par l'algorithme évolutionnaire en générant aléatoirement M scénarios de gestion de vitesse 550, et l'étape 609 consiste à générer M nouveaux scénarios de gestion de vitesse 550 par croisement et mutation des scénarios de gestion de vitesse 550 sélectionnés à l'étape 608.

Si au contraire le critère d'arrêt est vérifié (repère « O » en 607 sur la figure 12), on passe à une étape 610 consistant à sélectionner le scénario de gestion de vitesse 550 qui minimise le mieux la fonction objectif calculée à l'étape 606. Enfin, à l'étape 611, ce scénario de gestion de vitesse 550 est désigné comme la courbe de vitesse de navire 1 le long dudit trajet prévisionnel, après quoi les étapes 305 à 310 et les évaluations S1, S2, ..., SN peuvent être mises en oeuvre comme on l'a déjà décrit ci-dessus.

La configuration du système de traitement de phase vapeur 10 représentée sur la figure 2 n'est qu'un exemple. D'autres configurations sont possibles.

Dans certaines variantes non représentées, le navire 1 peut comporter plus d'un moteur 40. Dans ce cas, le modèle moteur 61 est apte à estimer la puissance requise en sortie de chaque moteur 40 en fonction d'une consigne de vitesse du navire 1, du au moins un paramètre environnemental, et éventuellement du cap du navire 1.

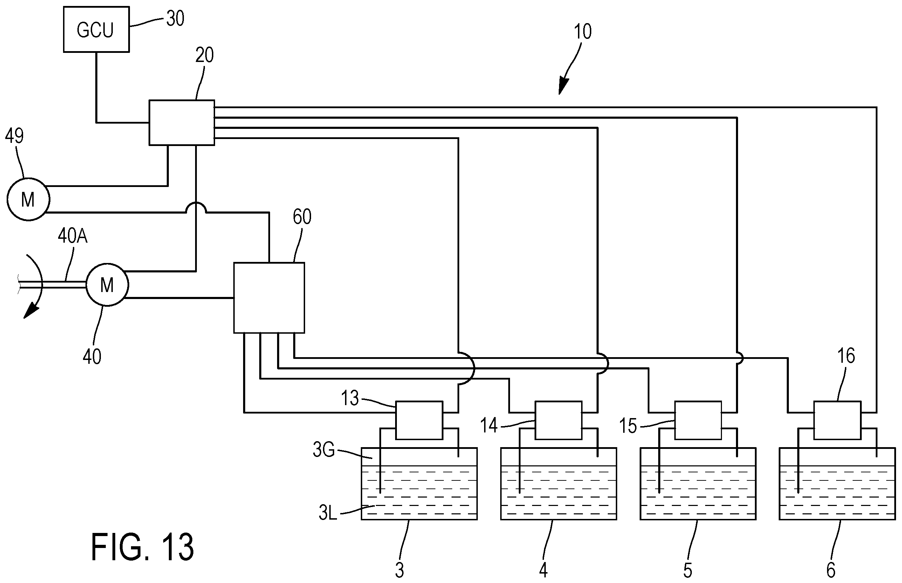

Comme on l'a mentionné ci-dessus en rapport avec la figure 2, le moteur 40 peut fournir à la fois la puissance nécessaire à la propulsion du navire 1 et la puissance nécessaire à l'alimentation électrique d'autres équipements du navire 1 (dénommée couramment « Hotel Load » en anglais). Toutefois, comme représenté sur la figure 13, le navire 1 peut comporter un moteur auxiliaire 49 destiné à fournir cette puissance « Hotel Load ». Le moteur auxiliaire 49 est, comme le moteur 40, apte à consommer du BOG provenant de l'unité de distribution de BOG 20 ou du BOG provenant du réchauffeur 60. Dans ce cas, le modèle moteur 61 est apte à estimer la puissance requise en sortie du moteur 40 et du moteur auxiliaire 49 en fonction d'une consigne de vitesse du navire 1, du au moins un paramètre environnemental, et éventuellement du cap du navire 1. On précise en outre qu'en variante, plusieurs moteurs auxiliaires 49 peuvent être prévus ; dans ce cas, de façon analogue, le modèle moteur 61 est apte à estimer la puissance requise en sortie du ou des moteurs 40 et des moteurs auxiliaires 49.

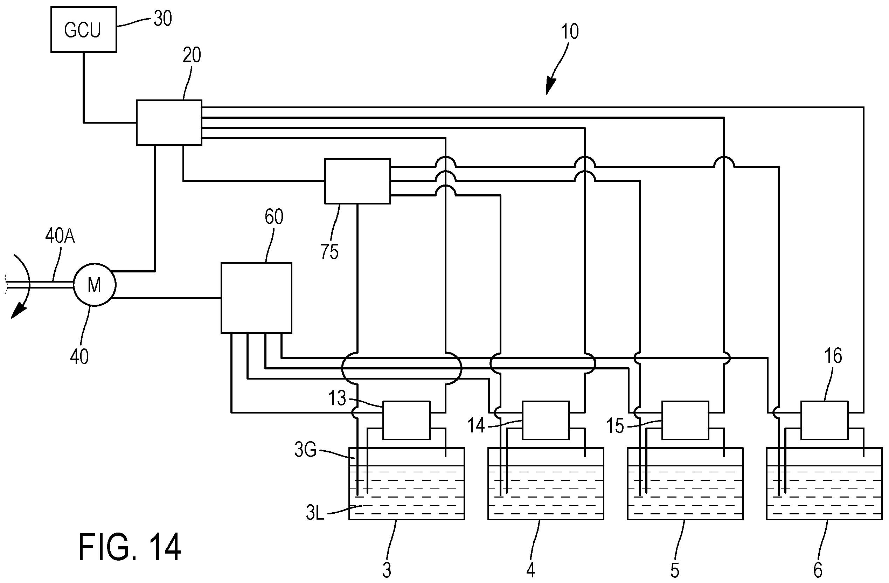

On a représenté sur la figure 14 une autre variante du système de traitement de phase vapeur 10, qui comporte en outre un reliquéfacteur 75 (« reliquefaction plant » en anglais).

De façon connue en soi, le reliquéfacteur 75 est apte à recevoir du BOG provenant de l'unité de distribution de BOG 20, à le reliquéfier, et à le renvoyer vers les cuves 3, 4, 5, 6. Un tel reliquéfacteur 75 est connu en tant que tel et n'est donc pas décrit en détail ici.

On précise que de façon non représentée sur la figure 14, la puissance (par exemple une puissance électrique) nécessaire au fonctionnement du reliquéfacteur 75 peut être fournie par le moteur 40 ou bien par le moteur auxiliaire 49. On précise en outre que dans certaines variantes non représentées, le reliquéfacteur 75 peut n'envoyer du BOG reliquéfié que vers une ou certaines des cuves 3, 4, 5, 6.

Bien entendu, dans cette variante, le modèle de flux 63 tient compte de la présence du reliquéfacteur 75.

Plus concrètement, le modèle de flux 63 est apte à estimer une quantité de gaz à extraire de la cuve 3 par le sous-système de traitement de phase vapeur 13, une quantité de BOG à brûler dans la GCU 30, et en outre une quantité de BOG à envoyer au reliquéfacteur 75. Plus concrètement, le modèle de flux 63 estime, à partir de la puissance estimée par le modèle 61, une quantité de BOG à fournir au moteur 40, et compare cette quantité de BOG à fournir au moteur 40 avec la quantité de BOG générée dans la cuve 3 estimée par le modèle de cuve 62. Si la quantité de BOG à fournir au moteur 40 est supérieure à la quantité de BOG générée dans la cuve 3, le modèle de flux 63 détermine que la différence entre ces deux quantités est à extraire de la cuve 3 par le sous-système de traitement de phase vapeur 13. Inversement, si la quantité de BOG à fournir au moteur 40 est inférieure à la quantité de BOG générée dans la cuve 3, le modèle de flux 63 détermine que la différence entre ces deux quantités est à envoyer préférentiellement au reliquéfacteur 75, et en outre à brûler dans la GCU 30 seulement si la capacité de reliquéfaction du reliquéfacteur 75 est insuffisante.

Il est en outre bien entendu que dans cette variante, à l'étape 403, à partir de la courbe de puissance requise en sortie du moteur 40 estimée à l'étape 401 et de la courbe de quantité de BOG générée dans la cuve 3 estimée à l'étape 402, une courbe de quantité de gaz à extraire de la cuve 3, une courbe de quantité de BOG à brûler dans la GCU 30, et une courbe de quantité de BOG à envoyer au reliquéfacteur 75 sont estimées à l'aide du modèle de flux 63.

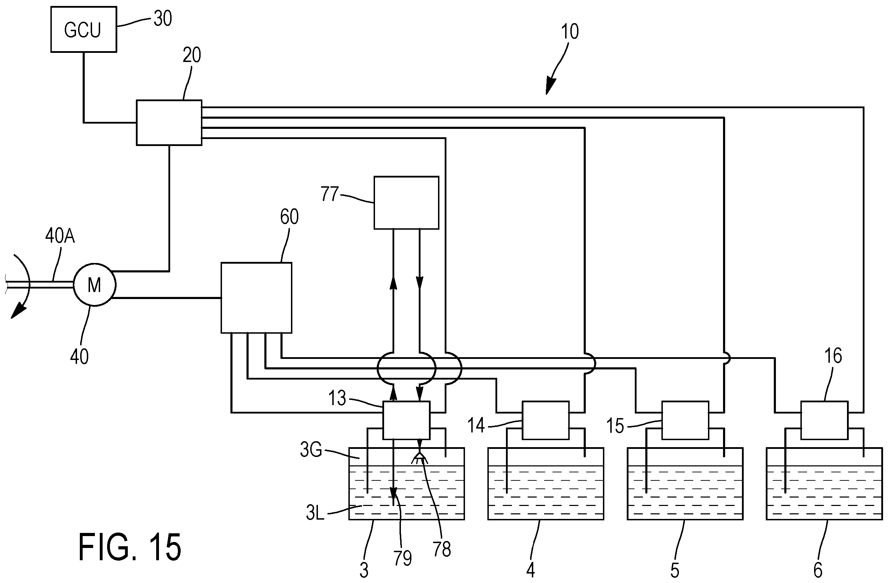

On a représenté sur la figure 15 encore une autre variante du système de traitement de phase vapeur 10, qui comporte en outre un sous-refroidisseur 77 (« subcooler » en anglais).

De façon connue en soi, le sous-refroidisseur 77 est apte à recevoir du sous-système de traitement de phase vapeur 13 une portion de la phase liquide 3L contenue dans la cuve 3 et à abaisser sa température (par exemple d'environ 5 à 10 degrés Celsius, soit d'environ -162°C à environ -167°C à -172°C dans le cas où le gaz liquéfié est du GNL à pression atmosphérique). Le sous-refroidisseur 77 est en outre apte à renvoyer la phase liquide ainsi sous-refroidie vers la cuve 3, soit directement dans la phase liquide 3L au moyen d'une buse de mélange (« mixing nozzle » en anglais) 79 connue en tant que telle, soit indirectement par pulvérisation (« spraying » en anglais) dans la phase gazeuse 3G sous forme de gouttelettes au moyen d'une rampe de pulvérisation (« spraying ramp » en anglais) 78 connue en tant que telle.

On précise que de façon non représentée sur la figure 15, la puissance (par exemple une puissance électrique) nécessaire au fonctionnement du sous-refroidisseur 77 peut être fournie par le moteur 40 ou bien par le moteur auxiliaire 49. On précise en outre que dans certaines variantes non représentées, le sous-refroidisseur 77 peut être apte à extraire la phase liquide de plusieurs voire toutes des cuves 3, 4, 5, 6 et à la renvoyer sous-refroidie vers la cuve respective.

Bien entendu, dans cette variante, le modèle de flux 63 tient compte de la présence du sous-refroidisseur 77.

Plus concrètement, le modèle de flux 63 est apte à estimer une quantité de gaz à extraire de la cuve 3 par le sous-système de traitement de phase vapeur 13, une quantité de BOG à brûler dans la GCU 30, et en outre une quantité de phase liquide à envoyer au sous-refroidisseur 77. Plus concrètement, le modèle de flux 63 estime, à partir de la puissance estimée par le modèle 61, une quantité de BOG à fournir au moteur 40, et compare cette quantité de BOG à fournir au moteur 40 avec la quantité de BOG générée dans la cuve 3 estimée par le modèle de cuve 62. Si la quantité de BOG à fournir au moteur 40 est supérieure à la quantité de BOG générée dans la cuve 3, le modèle de flux 63 détermine que la différence entre ces deux quantités est à extraire de la cuve 3 par le sous-système de traitement de phase vapeur 13. Inversement, si la quantité de BOG à fournir au moteur 40 est inférieure à la quantité de BOG générée dans la cuve 3, le modèle de flux 63 détermine que la différence entre ces deux quantités est à réduire au fil du temps en faisant fonctionner préférentiellement le sous-refroidisseur 77, l'éventuel excès de BOG étant à brûler dans la GCU 30 seulement si la capacité de sous-refroidissement du sous-refroidisseur 77 est insuffisante.

Il est en outre bien entendu que dans cette variante, à l'étape 403, à partir de la courbe de puissance requise en sortie du moteur 40 estimée à l'étape 401 et de la courbe de quantité de BOG générée dans la cuve 3 estimée à l'étape 402, une courbe de quantité de gaz à extraire de la cuve 3, une courbe de quantité de BOG à brûler dans la GCU 30, et une courbe de quantité de phase liquide à extraire de la cuve 3 et à envoyer vers le sous-refroidisseur 77 sont estimées à l'aide du modèle de flux 63.

On précise enfin que dans certaines variantes non représentées, le sous-refroidisseur 77 peut être apte à extraire la phase liquide de l'une des cuves 3, 4, 5, 6 et à la renvoyer sous-refroidie vers une ou plusieurs autres des cuves 3, 4, 5, 6. Dans ce cas, lorsque le procédé d'aide à la gestion 300 est mis en œuvre simultanément pour plusieurs ou chacune des cuves 3, 4, 5, 6 comme on l'a mentionné ci-dessus, le modèle de flux 63 afférent à une cuve donnée estime en outre une quantité de phase liquide sous-refroidie à recevoir du sous-refroidisseur 77 en provenance d'autre(s) cuve(s).

Bien que l'invention ait été décrite en liaison avec plusieurs modes d'exécution particuliers, il est bien évident qu'elle n'y est nullement limitée et qu'elle comprend tous les équivalents techniques des moyens décrits ainsi que leurs combinaisons si celles-ci entrent dans le cadre de l'invention.

L'usage du verbe « comporter », « comprendre » ou « inclure » et de ses formes conjuguées n'exclut pas la présence d'autres éléments ou d'autres étapes que ceux énoncés dans une revendication.

Dans les revendications, tout signe de référence entre parenthèses ne saurait être interprété comme une limitation de la revendication.

## Revendications

1. Procédé mis en œuvre par ordinateur d'aide à la gestion d'un navire (1) de transport de gaz liquéfié, le navire comportant au moins une cuve (3) configurée pour contenir du gaz liquéfié et un système de traitement de phase vapeur (10), le système de traitement de phase vapeur (10) étant apte à envoyer du gaz d'évaporation sortant de la cuve (3) vers un moteur de propulsion (40) du navire et vers une unité de combustion de gaz (30) embarquée à bord du navire, le système de traitement de phase vapeur (10) étant en outre apte à extraire une portion de la phase liquide (3L) contenue dans la cuve (3) et à évaporer cette portion afin de l'envoyer vers le moteur de propulsion (40), le procédé comportant :
- fournir (301) un état initial de la cuve, ledit état initial de la cuve comprenant une pression initiale de la phase gazeuse (3G) contenue dans la cuve (3) et une température initiale de la phase liquide (3L) contenue dans la cuve (3) ;
- fournir (302) un trajet prévisionnel (80) du navire (1) ;
- à partir de prévisions météorologiques, déterminer (303) au moins un paramètre environnemental du navire le long dudit trajet prévisionnel (80) ;
- déterminer (304) une courbe de vitesse du navire (1) le long dudit trajet prévisionnel (80) ;
le procédé étant **caractérisé en ce qu'**il comporte :
- générer (305) un scénario de gestion de cuve (50 ; 50A) définissant une évolution de la pression de la phase gazeuse (3G) contenue dans la cuve pendant ledit trajet prévisionnel (80), et à partir du scénario de gestion de cuve ainsi généré :
a) estimer (401) une courbe de puissance requise en sortie du moteur de propulsion (40) le long dudit trajet prévisionnel (80) en fonction de ladite courbe de vitesse du navire et dudit au moins un paramètre environnemental ;
b) estimer (402) une courbe de quantité de gaz d'évaporation générée dans la cuve (3) le long dudit trajet prévisionnel ;
c) estimer (403), à partir de ladite courbe de puissance requise et de ladite courbe de quantité de gaz d'évaporation générée, une courbe de quantité de gaz à extraire de la cuve et une courbe de quantité de gaz d'évaporation à brûler dans l'unité de combustion de gaz (30) ; et
d) calculer (404) une fonction de coût qui dépend au moins d'une quantité totale de gaz d'évaporation générée dans la cuve le long dudit trajet prévisionnel (80) ; et
- afficher (310) à un utilisateur le scénario de gestion de cuve (50 ; 50A) en fonction de la fonction de coût calculée.

2. Procédé selon la revendication 1, dans lequel une pluralité de scénarios de gestion de cuve (50 ; 50A) sont générés, les étapes a) à d) étant effectuées pour chaque scénario de gestion de cuve, et dans lequel au moins un desdits scénarios de gestion de cuve est affiché à l'utilisateur en fonction de la fonction de coût calculée pour ledit scénario de gestion de cuve.

3. Procédé selon la revendication 2, dans lequel avant d'afficher (310) à l'utilisateur au moins un desdits scénarios de gestion de cuve (50 ; 50A), lesdits scénarios de gestion de cuve sont régénérés itérativement une pluralité de fois par un premier algorithme évolutionnaire utilisant la fonction de coût comme première fonction objectif.

4. Procédé selon l'une quelconque des revendications 1 à 3, dans lequel ledit trajet prévisionnel (80) comprend des étapes de trajet (84) définies chacune par deux points de cheminement (83) et un cap à suivre entre lesdits deux points de cheminement, et dans lequel à l'étape a), la courbe de puissance requise en sortie du moteur de propulsion (40) le long dudit trajet prévisionnel (80) est estimée en fonction desdits caps à cuivre, de ladite courbe de vitesse du navire et dudit au moins un paramètre environnemental.

5. Procédé selon l'une quelconque des revendications 1 à 4, dans lequel ladite courbe de vitesse du navire est déterminée à partir dudit trajet prévisionnel (80) et dudit au moins un paramètre environnemental par un deuxième algorithme évolutionnaire utilisant une deuxième fonction objectif qui dépend de ladite quantité totale de gaz d'évaporation générée dans la cuve le long dudit trajet prévisionnel (80) et d'une différence entre une heure requise d'arrivée à destination et une heure estimée d'arrivée à destination.

6. Procédé selon l'une quelconque des revendications 1 à 5, dans lequel fournir (302) un trajet prévisionnel (80) du navire comprend fournir une pression de déchargement et/ou une température de déchargement requises par un terminal de déchargement à la destination du navire, et dans lequel à l'étape d), la fonction de coût dépend en outre d'une différence entre la pression de la phase gazeuse (3G) contenue dans la cuve (3) à la fin du dudit trajet prévisionnel (80) et ladite pression de déchargement et/ou d'une différence entre la température de la phase liquide (3L) contenue dans la cuve (3G) à la fin du dudit trajet prévisionnel (80) et ladite température de déchargement.

7. Procédé selon l'une quelconque des revendications 1 à 6, dans lequel à l'étape a), la courbe de puissance requise est estimée à l'aide d'un premier modèle statistique, le premier modèle statistique étant apte à estimer une puissance requise en sortie du moteur de propulsion (40) au moins en fonction d'une consigne de vitesse de navire et dudit au moins un paramètre environnemental, et le premier modèle statistique étant entraîné par une méthode d'apprentissage automatique supervisé.

8. Procédé selon l'une quelconque des revendications 1 à 7, dans lequel la susdite étape b) consistant à estimer (402) une courbe de quantité de gaz d'évaporation générée dans la cuve (3) le long dudit trajet prévisionnel (80) comprend estimer une première quantité de gaz d'évaporation générée dans la cuve en fonction d'une pression courante de la phase gazeuse (3G) contenue dans la cuve et d'une température courante de la phase liquide (3L) contenue dans la cuve et estimer une deuxième quantité de gaz d'évaporation générée dans la cuve en fonction d'une pression courante de la phase gazeuse (3G) contenue dans la cuve et dudit au moins un paramètre environnemental.

9. Procédé selon la revendication 8, dans lequel la deuxième quantité de gaz d'évaporation générée dans la cuve (3) est estimée à l'aide d'un deuxième modèle statistique, le deuxième modèle statistique étant entraîné par une méthode d'apprentissage automatique supervisé.

10. Procédé selon l'une quelconque des revendications 1 à 9, dans lequel l'état initial comprend une composition initiale du gaz liquéfié contenu dans la cuve, et dans lequel l'étape b) consistant à estimer (402) une courbe de quantité de gaz d'évaporation générée dans la cuve (3) le long dudit trajet prévisionnel (80) comprend en outre estimer une composition du gaz d'évaporation généré dans la cuve.

11. Procédé selon l'une quelconque des revendications 1 à 10, dans lequel le paramètre environnemental comprend au moins l'un parmi une direction du courant, une vitesse du courant, une vitesse du vent, une direction du vent, une hauteur moyenne des vagues, une direction des vagues, et une période des vagues.

12. Procédé selon l'une quelconque des revendications 1 à 11, dans lequel le système de traitement de phase vapeur (10) comporte en outre un reliquéfacteur (75) apte à reliquéfier du gaz d'évaporation sortant de la cuve (3) et à renvoyer le gaz d'évaporation ainsi reliquéfié vers la cuve, et dans lequel la susdite étape c) comprend estimer (403), à partir de ladite courbe de puissance requise et de ladite courbe de quantité de gaz d'évaporation générée, une courbe de quantité de gaz à extraire de la cuve, une courbe de quantité de gaz d'évaporation à brûler dans l'unité de combustion de gaz (30), et une courbe de quantité de gaz d'évaporation à envoyer vers le reliquéfacteur (75).

13. Procédé selon l'une quelconque des revendications 1 à 12, dans lequel le système de traitement de phase vapeur (10) comporte en outre un sous-refroidisseur (77) apte à sous-refroidir une portion de la phase liquide (3L) contenue dans la cuve (3) et à renvoyer la portion ainsi sous-refroidie vers la cuve, et dans lequel la susdite étape c) comprend estimer (403), à partir de ladite courbe de puissance requise et de ladite courbe de quantité de gaz d'évaporation générée, une courbe de quantité de gaz à extraire de la cuve, une courbe de quantité de gaz d'évaporation à brûler dans l'unité de combustion de gaz (30), et une courbe de quantité de phase liquide à extraire de la cuve et à envoyer vers le sous-refroidisseur (77).

14. Procédé selon l'une quelconque des revendications 1 à 13, dans lequel les étapes du procédé selon la revendication 1 sont réitérées à intervalles fixes et/ou à réception de nouvelles prévisions météorologiques.

15. Système (100, 200) d'aide à la gestion d'un navire de transport de gaz liquéfié, le navire (1) comportant au moins une cuve (3) configurée pour contenir du gaz liquéfié et un système de traitement de phase vapeur (10), le système de traitement de phase vapeur (10) étant apte à envoyer du gaz d'évaporation sortant de la cuve (3) vers un moteur de propulsion (40) du navire et vers une unité de combustion de gaz (30) embarquée à bord du navire, le système de traitement de phase vapeur (10) étant en outre apte à extraire une portion de la phase liquide (3L) contenue dans la cuve (3) et à évaporer cette portion afin de l'envoyer vers le moteur de propulsion (40), le système (100, 200) d'aide à la gestion comprenant :
- une unité d'acquisition (42) configurée pour acquérir un état initial de la cuve et un trajet prévisionnel (80) du navire, ledit état initial de la cuve comprenant une pression initiale de la phase gazeuse (3G) contenue dans la cuve (3) et une température initiale de la phase liquide (3L) contenue dans la cuve (3) ;
- une première unité de communication (130) configurée pour obtenir des prévisions météorologiques d'un fournisseur de prévisions météorologiques ;
le système d'aide à la gestion étant **caractérisé en ce qu'**il comprend :
- une unité de calcul (110) configurée pour : à partir des prévisions météorologiques obtenues par la première unité de communication (130), déterminer (303) au moins un paramètre environnemental du navire le long dudit trajet prévisionnel (80) ; déterminer (304) une courbe de vitesse du navire le long dudit trajet prévisionnel (80) ; générer (305) un scénario de gestion de cuve (50 ; 50A) définissant une évolution de la pression de la phase gazeuse (3G) contenue dans la cuve (3) le long dudit trajet prévisionnel (80), et à partir du scénario de gestion de cuve ainsi généré :
a) estimer (401) une courbe de puissance requise en sortie du moteur de propulsion (40) le long dudit trajet prévisionnel (80) en fonction de ladite courbe de vitesse du navire et dudit au moins un paramètre environnemental ;
**b) estimer** (402) une courbe de quantité de gaz d'évaporation générée dans la cuve (3) le long dudit trajet prévisionnel ;
c) estimer (403), à partir de ladite courbe de puissance requise et de ladite courbe de quantité de gaz d'évaporation générée, une courbe de quantité de gaz à extraire de la cuve et une courbe de quantité de gaz d'évaporation à brûler dans l'unité de combustion de gaz (30) ;
d) calculer (404) une fonction de coût qui dépend au moins d'une quantité totale de gaz d'évaporation générée dans la cuve le long dudit trajet prévisionnel (80) ; et
- une unité d'affichage (41) configurée pour afficher à un utilisateur le scénario de gestion de cuve (50 ; 50A) en fonction de la fonction de coût calculée.

16. Système (100, 200) selon la revendication 15, dans lequel ledit trajet prévisionnel (80) comprend des étapes de trajet (84) définies chacune par deux points de cheminement (83) et un cap à suivre entre lesdits deux points de cheminement, et dans lequel l'unité de calcul (110) est configurée pour a) estimer (401) une courbe de puissance requise en sortie du moteur de propulsion (40) le long dudit trajet prévisionnel (80) en fonction desdits caps à cuivre, de ladite courbe de vitesse du navire et dudit au moins un paramètre environnemental.

17. Système (200) selon la revendication 15 ou 16, dans lequel l'unité d'acquisition (42) et l'unité d'affichage (41) sont embarquées à bord du navire, la première unité de communication (130) et l'unité de calcul (110) sont situées dans une station à terre (1000), et dans lequel le système comprend en outre une deuxième unité de communication (230) configurée pour mettre en communication l'unité d'acquisition (42) et l'unité de calcul (110).

## Patentansprüche

1. Computergestütztes Verfahren zur Unterstützung des Managements eines Flüssiggas-Transportschiffes (1), das Schiff umfassend mindestens einen zur Aufnahme von Flüssiggas ausgebildeten Tank (3) und ein Dampfphasen-Behandlungssystem (10), wobei das Dampfphasen-Behandlungssystem (10) dazu eingerichtet ist, den Tank (3) verlassenden Abdampf zu einem Antriebsmotor (40) des Schiffes und zu einer Gasverbrennungseinheit (30) an Bord des Schiffes zu leiten, wobei das Dampfphasen-Behandlungssystem (10) außerdem dazu ausgebildet ist, einen Teil der im Tank (3) enthaltenen Flüssigphase (3L) zu entnehmen und diesen Teil zu verdampfen, um ihn zum Antriebsmotor (40) zu leiten, wobei das Verfahren umfasst:
- Bereitstellen (301) eines Anfangszustands des Tanks, wobei der Anfangszustand des Tanks einen Anfangsdruck der im Tank (3) enthaltenen Gasphase (3G) und eine Anfangstemperatur der im Tank (3) enthaltenen Flüssigphase (3L) umfasst;
- Bereitstellen (302) einer geplanten Route (80) des Schiffes (1);
- Bestimmen (303) mindestens eines Umgebungsparameters des Schiffes auf der geplanten Route (80) auf der Grundlage von Wettervorhersagen;
- Bestimmen (304) einer Geschwindigkeitskurve des Schiffes (1) auf der geplanten Route (80);
wobei das Verfahren **dadurch gekennzeichnet ist, dass** dieses umfasst:
- Erzeugen (305) eines Tankmanagement-Szenarios (50; 50A), das eine Druckentwicklung der im Tank enthaltenen Gasphase (3G) auf der geplanten Route (80) definiert, und ausgehend von dem so erzeugten Tankmanagement-Szenario:
a) Schätzen (401) einer erforderlichen Leistungskurve am Ausgang des Antriebsmotors (40) auf der genannten geplanten Route (80) in Abhängigkeit von der genannten Geschwindigkeitskurve des Schiffes und dem genannten mindestens einen Umgebungsparameter;
b) Schätzen (402) einer Kurve des im Tank (3) erzeugten Abdampfes auf der geplanten Route;
c) Schätzen (403) einer Kurve der dem Tank zu entnehmenden Gasmenge und einer Kurve der in der Gasverbrennungseinheit (30) zu verbrennenden Abdampfmenge auf der Grundlage der erforderlichen Leistungskurve und der Kurve der erzeugten Abdampfmenge; und
d) Berechnen (404) einer Kostenfunktion, die zumindest von einer Gesamtmenge an Abdampf abhängig ist, die auf der geplanten Route (80) im Tank erzeugt wird; und
- Anzeigen (310) des Tankmanagement-Szenarios (50; 50A) für einen Benutzer in Abhängigkeit von der berechneten Kostenfunktion.

2. Verfahren nach Anspruch 1, wobei eine Vielzahl von Tankmanagement-Szenarien (50; 50A) generiert wird, wobei die Schritte a) bis d) für jedes Tankmanagement-Szenario durchgeführt werden und wobei mindestens eines der Tankmanagement-Szenarien dem Benutzer in Abhängigkeit von der für das Tankmanagement-Szenario berechneten Kostenfunktion angezeigt wird.

3. Verfahren nach Anspruch 2, wobei vor dem Anzeigen (310) mindestens eines der Tankmanagement-Szenarien (50; 50A) für den Benutzer die Tankmanagement-Szenarien durch einen ersten Evolutionsalgorithmus unter Verwendung der Kostenfunktion als erste Zielfunktion iterativ mehrmals neu generiert werden.

4. Verfahren nach einem der Ansprüche 1 bis 3, wobei die geplante Route (80) Routenabschnitte (84) umfasst, die jeweils durch zwei Wegpunkte (83) und einen zwischen diesen beiden Wegpunkten zu verfolgenden Kurs definiert sind, und wobei in Schritt a) die erforderliche Leistungskurve am Ausgang des Antriebsmotors (40) auf der geplanten Route (80) in Abhängigkeit von den zu verfolgenden Kursen, der Geschwindigkeitskurve des Schiffes und dem mindestens einen Umgebungsparameter geschätzt wird.

5. Verfahren nach einem der Ansprüche 1 bis 4, wobei die Geschwindigkeitskurve des Schiffes anhand der geplanten Route (80) und dem mindestens einen Umgebungsparameter durch einen zweiten Evolutionsalgorithmus unter Verwendung einer zweiten Zielfunktion bestimmt wird, die von der Gesamtmenge des auf der geplanten Route (80) im Tank erzeugten Verdampfungsgases und einer Differenz zwischen einer geforderten Ankunftszeit am Zielort und einer voraussichtlichen Ankunftszeit am Zielort abhängt.

6. Verfahren nach einem der Ansprüche 1 bis 5, wobei das Bereitstellen (302) einer geplanten Route (80) des Schiffes das Bereitstellen eines von einem Entlade-Terminal am Zielort des Schiffes geforderten Entladedrucks und/oder einer geforderten Entladetemperatur umfasst und wobei in Schritt d) die Kostenfunktion ferner von einer Differenz zwischen dem Druck der Gasphase (3G) im Tank (3) am Ende der geplanten Route (80) und dem Entladedruck und/oder einer Differenz zwischen der Temperatur der Flüssigphase (3L) im Tank (3G) am Ende der geplanten Route (80) und der Entladetemperatur abhängig ist.

7. Verfahren nach einem der Ansprüche 1 bis 6, wobei in Schritt a) die erforderliche Leistungskurve mit Hilfe eines ersten statistischen Modells geschätzt wird, wobei das erste statistische Modell geeignet ist, eine erforderliche Ausgangsleistung des Antriebsmotors (40) zumindest in Abhängigkeit von einem Sollwert für die Geschwindigkeit des Schiffes und dem mindestens einen Umgebungsparameter zu schätzen, und wobei das erste statistische Modell durch ein überwachtes maschinelles Lernverfahren trainiert wird.

8. Verfahren nach einem der Ansprüche 1 bis 7, wobei der vorangehend genannte Schritt b) zum Schätzen (402) einer Kurve der auf der vorangehend genannten geplanten Route (80) im Tank (3) erzeugten Abdampfmenge das Schätzen einer ersten im Tank erzeugten Abdampfmenge in Abhängigkeit von einem aktuellen Druck der im Tank enthaltenen Gasphase (3G) und einer aktuellen Temperatur der im Tank enthaltenen Flüssigphase (3L) und das Schätzen einer zweiten im Tank erzeugten Abdampfmenge in Abhängigkeit von einem aktuellen Druck der im Behälter enthaltenen Gasphase (3G) und dem mindestens einen Umgebungsparameter umfasst.

9. Verfahren nach Anspruch 8, wobei die im Tank (3) erzeugte zweite Abdampfmenge mit Hilfe eines zweiten statistischen Modells geschätzt wird, wobei das zweite statistische Modell durch ein überwachtes maschinelles Lernverfahren trainiert wird.

10. Verfahren nach einem der Ansprüche 1 bis 9, wobei der Anfangszustand eine Anfangszusammensetzung des im Tank enthaltenen verflüssigten Gases umfasst und wobei der Schritt b) des Schätzens (402) einer Kurve der im Tank (3) erzeugten Abdampfmenge auf der geplanten Route (80) ferner das Schätzen einer Zusammensetzung des im Tank erzeugten Abdampfes umfasst.

11. Verfahren nach einem der Ansprüche 1 bis 10, wobei der Umgebungsparameter mindestens einen der folgenden Parameter umfasst: Strömungsrichtung, Strömungsgeschwindigkeit, Windgeschwindigkeit, Windrichtung, durchschnittliche Wellenhöhe, Wellenrichtung und Wellenperiode.

12. Verfahren nach einem der Ansprüche 1 bis 11, wobei das Dampfphasen-Behandlungssystem (10) außerdem einen Rückverflüssiger (75) umfasst, der geeignet ist, den Tank (3) verlassenden Abdampf wieder zu verflüssigen und den auf diese Weise wieder verflüssigten Abdampf zum Tank zurückzuführen, und wobei der oben genannte Schritt c) umfasst, ausgehend von der genannten erforderlichen Leistungskurve und der genannten Kurve der erzeugten Abdampfmenge eine Kurve der dem Behälter zu entnehmenden Gasmenge, eine Kurve der in der Gasverbrennungseinheit (30) zu verbrennenden Abdampfmenge und eine Kurve der zum Verflüssiger (75) zu leitenden Abdampfmenge zu schätzen.

13. Verfahren nach einem der Ansprüche 1 bis 12, wobei das Dampfphasen-Behandlungssystem (10) außerdem einen Unterkühler (77) umfasst, der einen Teil der im Behälter (3) enthaltenen Flüssigphase (3L) unterkühlen und den so unterkühlten Teil zum Tank zurückführen kann, und wobei der oben genannte Schritt c) umfasst, ausgehend von der genannten erforderlichen Leistungskurve und der genannten Kurve der erzeugten Abdampfmenge eine Kurve der dem Tank zu entnehmenden Gasmenge, eine Kurve der in der Gasverbrennungseinheit (30) zu verbrennenden Abdampfmenge und eine Kurve der dem Tank zu entnehmenden und zum Unterkühler (77) zu leitenden Flüssigphasenmenge umfasst.

14. Verfahren nach einem der Ansprüche 1 bis 13, wobei die Schritte des Verfahrens nach Anspruch 1 in festen Intervallen und/oder bei Erhalt neuer Wettervorhersagen wiederholt werden.

15. System (100, 200) zur Unterstützung des Managements eines Flüssiggas-Transportschiffes, wobei das Schiff (1) mindestens einen Tank (3) zur Aufnahme von Flüssiggas und ein Dampfphasen-Behandlungssystem (10) umfasst, wobei das Dampfphasen-Behandlungssystem (10) geeignet ist, den Tank (3) verlassenden Abdampf zu einem Antriebsmotor (40) des Schiffes und zu einer Gasverbrennungseinheit (30) an Bord des Schiffes zu leiten, wobei das Dampfphasenbehandlungssystem (10) außerdem geeignet ist, einen Teil der im Tank (3) enthaltenen Flüssigphase (3L) zu entnehmen und diesen Teil zu verdampfen, um ihn zum Antriebsmotor (40) zu leiten, wobei das Management-Unterstützungssystem (100, 200) umfasst:
- eine Erfassungseinheit (42), die konfiguriert ist für die Erfassung eines Anfangszustands des Tanks und einer geplanten Route (80) des Schiffes, wobei der Anfangszustand des Tanks einen Anfangsdruck der im Tank (3) enthaltenen Gasphase (3G) und eine Anfangstemperatur der im Tank (3) enthaltenen Flüssigphase (3L) umfasst;
- eine erste Kommunikationseinheit (130), die konfiguriert zum Beziehen von Wettervorhersagen von einem Wettervorhersageanbieter;
wobei das Management-Unterstützungssystem **dadurch gekennzeichnet ist, dass** dieses umfasst:
- eine Berechnungseinheit (110), die konfiguriert ist zum Bestimmen (303) mindestens eines Umgebungsparameters des Schiffes auf der genplanten Route anhand der von der ersten Kommunikationseinheit (130) erhaltenen Wettervorhersagen; zum Bestimmen (304) einer Geschwindigkeitskurve des Schiffes auf der geplanten Route (80); zum Erzeugen (305) eines Tankmanagement-Szenarios (50; 50A), das eine Druckentwicklung der im Tank (3) enthaltenen Gasphase (3G) auf der geplanten Route (80) definiert, und ausgehend von dem so erzeugten Tankmanagement-Szenario:
a) Schätzen (401) einer erforderlichen Leistungskurve am Ausgang des Antriebsmotors (40) auf der geplanten Route (80) in Abhängigkeit von der Geschwindigkeitskurve des Schiffes und dem mindestens einen Umgebungsparameter;
b) Schätzen (402) einer Kurve des auf der geplanten Route im Tank (3) erzeugten Abdampfes;
c) Schätzen (403) einer Kurve der dem Tank zu entnehmenden Gasmenge und einer Kurve des in der Gasverbrennungseinheit (30) zu verbrennenden Abdampfes anhand der erforderlichen Leistungskurve und der Kurve der erzeugten Abdampfmenge;
d) Berechnen (404) einer Kostenfunktion, die mindestens von einer Gesamtmenge an Abdampf abhängig ist, die auf der geplanten Route (80) im Tank erzeugt wird; und
- eine Anzeigeeinheit (41), die dazu eingerichtet ist, das Tankmanagement-Szenario (50; 50A) in Abhängigkeit von der berechneten Kostenfunktion für einen Benutzer anzuzeigen.

16. System (100, 200) nach Anspruch 15, wobei die geplante Route (80) Routenabschnitte (84) umfasst, die jeweils durch zwei Wegpunkte (83) und einen zwischen diesen beiden Wegpunkten zu verfolgenden Kurs definiert sind, und wobei die Berechnungseinheit (110) derart konfiguriert ist, dass sie a) eine erforderliche Leistungskurve am Ausgang des Antriebsmotors (40) auf der geplanten Route (80) in Abhängigkeit von den zu verfolgenden Kursen, der Geschwindigkeitskurve des Schiffes und dem mindestens einen Umgebungsparameter schätzt (401).

17. System (200) nach Anspruch 15 oder 16, wobei die Erfassungseinheit (42) und die Anzeigeeinheit (41) sich an Bord des Schiffes befinden, die erste Kommunikationseinheit (130) und die Berechnungseinheit (110) sich in einer Uferstation (1000) befinden, und wobei das System ferner eine zweite Kommunikationseinheit (230) umfasst, die derart konfiguriert ist, dass sie die Erfassungseinheit (42) und die Berechnungseinheit (110) miteinander verbindet.

## Claims

1. A computer-implemented method for assisting the management of a vessel (1) for transporting liquefied gas, the vessel comprising at least one tank (3) configured to contain liquefied gas and a vapor phase treatment system (10), the vapor phase treatment system (10) being capable of sending boil-off gas exiting the tank (3) to a propulsion engine (40) of the vessel or to a gas combustion unit (30) on board the vessel, the vapor phase treatment system (10) further being capable of extracting a portion of the liquid phase (3L) contained in the tank (3) and of evaporating this portion in order to send it to the propulsion engine (40), the method comprising:
- providing (301) an initial state of the tank, said initial state of the tank comprising an initial pressure of the gas phase (3G) contained in the tank (3) and an initial temperature of the liquid phase (3L) contained in the tank (3);
- providing (302) a forecast path (80) of the vessel (1);
- determining (303), on the basis of weather forecasts, at least one environmental parameter of the vessel along said forecast path (80);
- determining (304) a speed curve of the vessel (1) along said forecast path (80);
the method being **characterized in that** it comprises:
- generating (305) a tank management scenario (50; 50A) defining an evolution of the pressure of the gas phase (3G) contained in the tank during said forecast path (80), and, on the basis of the tank management scenario thus generated:
a) estimating (401) a curve of the power required to be output from the propulsion engine (40) along said forecast path (80) as a function of said speed curve of the vessel and of said at least one environmental parameter;
b) estimating (402) a curve of the amount of boil-off gas generated in the vessel (3) along said forecast path;
c) estimating (403), on the basis of said required power curve and of said curve of the amount of boil-off gas generated, a curve of the amount of gas to be extracted from the tank and a curve of the amount of boil-off gas to be burned in the gas combustion unit (30); and
d) computing (404) a cost function that at least depends on a total amount of boil-off gas generated in the tank along said forecast path (80); and
- displaying (310) to a user the tank management scenario (50; 50A) as a function of the computed cost function.

2. The method as claimed in claim 1, wherein multiple tank management scenarios (50; 50A) are generated, with steps a) to d) being carried out for each tank management scenario, and wherein at least one of said tank management scenarios is displayed to the user as a function of the computed cost function for said tank management scenario.

3. The method as claimed in claim 2, wherein, before displaying (310) at least one of said tank management scenarios (50; 50A) to the user, said tank management scenarios are iteratively regenerated a number of times by a first evolutionary algorithm using the cost function as a first objective function.

4. The method as claimed in any one of claims 1 to 3, wherein said forecast path (80) comprises path steps (84) each defined by two waypoints (83) and a heading to be followed between said two waypoints, and wherein, in step a), the curve of the power required to be output from the propulsion engine (40) along said forecast path (80) is estimated as a function of said headings to be followed, of said speed curve of the vessel and of said at least one environmental parameter.

5. The method as claimed in any one of claims 1 to 4, wherein said speed curve of the vessel is determined from said forecast path (80) and from said at least one environmental parameter by a second evolutionary algorithm using a second objective function that depends on said total amount of boil-off gas generated in the tank along said forecast path (80) and on a difference between a required time of arrival at the destination and an estimated time of arrival at the destination.

6. The method as claimed in any one of claims 1 to 5, wherein providing (302) a forecast path (80) of the vessel comprises providing an offloading pressure and/or an offloading temperature required by an offloading terminal at the destination of the vessel, and wherein, in step d), the cost function further depends on a difference between the pressure of the gas phase (3G) contained in the tank (3) at the end of said forecast path (80) and said offloading pressure and/or a difference between the temperature of the liquid phase (3L) contained in the tank (3) at the end of said forecast path (80) and said offloading temperature.

7. The method as claimed in any one of claims 1 to 6, wherein, in step a), the required power curve is estimated using a first statistical model, the first statistical model being capable of estimating a power required to be output from the propulsion engine (40) at least as a function of a vessel speed setpoint and of said at least one environmental parameter, and the first statistical model being trained by a supervised machine learning method.

8. The method as claimed in any one of claims 1 to 7, wherein the aforementioned step b) involving estimating (402) a curve of the amount of boil-off gas generated in the tank (3) along said forecast path (80) comprises estimating a first amount of boil-off gas generated in the tank as a function of a current pressure of the gas phase (3G) contained in the tank and of a current temperature of the liquid phase (3L) contained in the vessel and estimating a second amount of boil-off gas generated in the tank as a function of a current pressure of the gas phase (3G) contained in the tank and of said at least one environmental parameter.

9. The method as claimed in claim 8, wherein the second amount of boil-off gas generated in the tank (3) is estimated using a second statistical model, the second statistical model being trained by a supervised machine learning method.

10. The method as claimed in any one of claims 1 to 9, wherein the initial state comprises an initial composition of the liquefied gas contained in the tank, and wherein step b) involving estimating (402) a curve of the amount of boil-off gas generated in the tank (3) along said forecast path (80) further comprises estimating a composition of the boil-off gas generated in the tank.

11. The method as claimed in any one of claims 1 to 10, wherein the environmental parameter comprises at least one from among a current direction, a current speed, a wind speed, a wind direction, an average wave height, a wave direction, and a wave period.

12. The method as claimed in any one of claims 1 to 11, wherein the vapor phase treatment system (10) further comprises a reliquefaction plant (75) capable of reliquefying boil-off gas exiting the tank (3) and of returning the boil-off gas thus re-liquefied to the tank, and wherein the aforementioned step c) comprises estimating (403), on the basis of said required power curve and of said curve of the amount of boil-off gas generated, a curve of the amount of gas to be extracted from the tank, a curve of the amount of boil-off gas to be burned in the gas combustion unit (30), and a curve of the amount of boil-off gas to be sent to the reliquefaction plant (75).

13. The method as claimed in any one of claims 1 to 12, wherein the vapor phase treatment system (10) further comprises a sub-cooler (77) capable of sub-cooling a portion of the liquid phase (3L) contained in the vessel (3) and of returning the portion thus sub-cooled to the tank, and wherein the aforementioned step c) comprises estimating (403), on the basis of said required power curve and of said curve of the amount of boil-off gas generated, a curve of the amount of gas to be extracted from the tank, a curve of the amount of boil-off gas to be burned in the gas combustion unit (30), and a curve of the amount of liquid phase to be extracted from the tank and to be sent to the sub-cooler (77).

14. The method as claimed in any one of claims 1 to 13, wherein the steps of the method as claimed in claim 1 are repeated at fixed intervals and/or upon receipt of new weather forecasts.

15. A system (100, 200) for assisting the management of a vessel for transporting liquefied gas, the vessel (1) comprising at least one tank (3) configured to contain liquefied gas and a vapor phase treatment system (10), the vapor phase treatment system (10) being capable of sending boil-off gas exiting the tank (3) to a propulsion engine (40) of the vessel or to a gas combustion unit (30) on board the vessel, the vapor phase treatment system (10) further being capable of extracting a portion of the liquid phase (3L) contained in the tank (3) and of evaporating this portion in order to send it to the propulsion engine (40), the management assistance system (100, 200) comprising:
- an acquisition unit (42) configured to acquire an initial state of the tank and a forecast path (80) of the vessel, said initial state of the tank comprising an initial pressure of the gas phase (3G) contained in the tank (3) and an initial temperature of the liquid phase (3L) contained in the tank (3);
- a first communication unit (130) configured to obtain weather forecasts from a weather forecast provider;
the system for assisting the management being **characterized in that** it comprises:
- a computation unit (110) configured to: on the basis of weather forecasts obtained by the first communication unit (130), determine at least one environmental parameter of the vessel along said forecast path (80); determine (304) a speed curve of the vessel along said forecast path (80); generate (305) a tank management scenario (50; 50A) defining an evolution in the pressure of the gas phase (3G) contained in the tank (3) along said forecast path (80), and, on the basis of the tank management scenario thus generated, configured to:
a) estimate (401) a curve of the power required to be output from the propulsion engine (40) along said forecast path (80) as a function of said speed curve of the vessel and of said at least one environmental parameter;
b) estimate (402) a curve of the amount of boil-off gas generated in the tank (3) along said forecast path;
c) estimate (403), on the basis of said required power curve and of said curve of the amount of boil-off gas generated, a curve of the amount of gas to be extracted from the vessel and a curve of the amount of boil-off gas to be burned in the gas combustion unit (30);
d) compute (404) a cost function that at least depends on a total amount of boil-off gas generated in the tank along said forecast path (80); and comprising
- a display unit (41) configured to display to a user the tank management scenario (50; 50A) as a function of the computed cost function.

16. The system (100, 200) as claimed in claim 15, wherein said forecast path (80) comprises path steps (84) each defined by two waypoints (83) and a heading to be followed between said two waypoints, and wherein the computation unit (110) is configured to: a) estimate (401) a curve of the power required to be output from the propulsion engine (40) along said forecast path (80) as a function of said headings to be followed, of said speed curve of the vessel and of said at least one environmental parameter.

17. The system (200) as claimed in claim 15 or 16, wherein the acquisition unit (42) and the display unit (41) are on board the vessel, the first communication unit (130) and the computation unit (110) are located in a ground station (1000), and wherein the system further comprises a second communication unit (230) configured to connect the acquisition unit (42) and the computation unit (110).
